# EUROPEAN PATENT APPLICATION

(11) **EP 4 730 035 A1**
(43) Date of publication of application: **22.04.2026**
(21) Application number: 25207626.0
(22) Date of filing: 09.10.2025
(51) Int. Cl.: G03F 7/16, G03F 7/40, C08G 65/40

(54) **COMPOSITION FOR FORMING WAFER-EDGE-PROTECTION FILM, WAFER-EDGE-PROTECTION FILM FORMING METHOD, AND PATTERNING PROCESS**

(30) Priority: 15.10.2024 JP 2024179606
(71) Applicant: SHIN-ETSU CHEMICAL CO., LTD., Tokyo 1000005 (JP)
(72) Inventor: Niida, Keisuke, Niigata (JP)
(74) Representative: Schicker, Silvia

(57) **Abstract**

The present invention is a composition for forming a wafer-edge-protection film for forming a wafer-edge-protection film on a peripheral edge of a substrate, including a polymer (A) represented by the following general formula (1) and a solvent. In the formula (1), "W" represents -SO₂-, -C(=O)-, or -O-; R₁, R₂, R₃, R₄, and R₅ each independently represent a halogen atom, a monovalent organic group having 1 to 3 carbon atoms, or a hydroxy group; and "a", "b", "c", "d", and "e" each independently represent an integer of 0 to 4. This can provide a composition for forming a wafer-edge-protection film capable of providing a wafer-edge-protection film that can exhibit excellent dry etching resistance and excellent uniform coatablity, even on a wafer edge that is difficult to be coated.

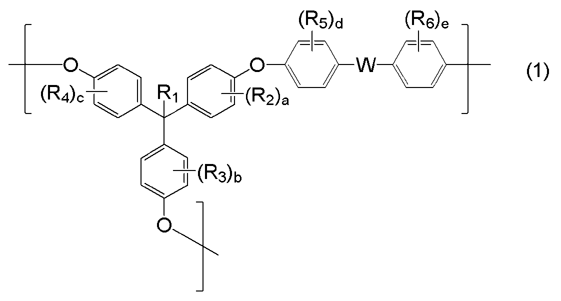

## Description

### TECHNICAL FIELD

The present invention relates to: a composition for forming wafer-edge-protection film for forming a wafer-edge-protection film on a peripheral edge of a substrate; a wafer-edge-protection film forming method using the composition for forming a wafer-edge-protection film; and a patterning process using the protection film.

### BACKGROUND ART

In the manufacturing process of a semiconductor device, for example, a resist coating process of applying a resist chemical onto a substrate, such as a semiconductor substrate, to form a resist upper layer film, an exposure process of exposing the resulting resist film to light having a predetermined pattern, a development process of developing the exposed resist upper layer film, and the like, are sequentially performed to form a resist pattern on the substrate. Then, while using the resist pattern as a mask, an etching process is performed on the substrate to form a predetermined pattern on the substrate.

In such substrate processing, when the substrate to be processed is etched while using the resist upper layer film pattern as a mask, if there is any substrate peripheral edge (wafer edge) which is a exposed portion of the substrate, there is a problem in which the exposed portion of the substrate is etched to generate particles, resulting in an influence on yield reduction of semiconductor manufacturing.

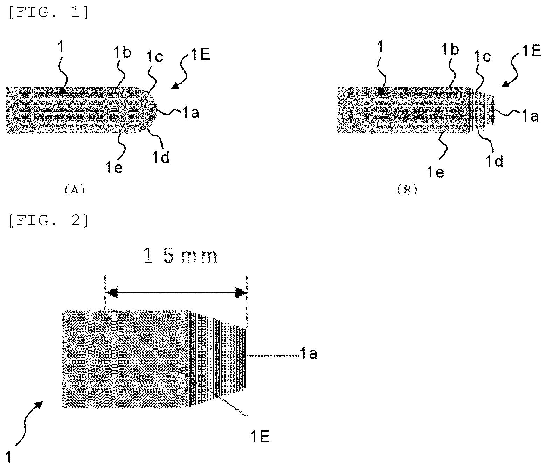

The wafer edge 1E (peripheral edge) usually has a shape in which the surface (an edge surface 1b on a front surface side and an edge surface 1e on a rear surface side) of the wafer 1 gradually slopes down and is cut off, as shown in FIG. 1. A beveled portion of the wafer edge 1E is referred to as "bevel", 1c and 1d, while a vertical portion is referred to as "apex" 1a. The shape of the wafer edge 1E shown in FIG. 1 (A) is called "round type", and the shape of the wafer edge shown in FIG. 1 (B) is called "bullet type".

In order to suppress particle generation from the wafer edge, a technique to form a resist film only on the wafer edge has been known. For example, as disclosed in Patent Document 1, a method of applying a photoresist solution onto the wafer edge while rotating the wafer has been known.

Further, in recent years, it has been considered to form a coating film using a coating type material containing an inorganic metal as a resist film (resist upper layer film) or a resist underlayer film. Since metal adhesion to an unintended part of a semiconductor substrate in a manufacturing process of semiconductor devices strongly affects the electric properties of a semiconductor devices, strict controls have been in place to prevent such metal adhesion.

However, during the formation of a coating film containing a metal described above, there is a concern that chemical liquid supplied onto a front surface of a substrate may run to a wafer edge or a peripheral edge on a rear surface, thus forming a coating film also on these unintended parts, i.e., the wafer edge and the peripheral edge on the rear surface, resulting in metal contamination in these areas. There is also concern that particles generated in etching of a metal-containing film may adhere to a wafer edge, resulting in metal contamination in these areas. Further, if the contaminated areas of the substrate come into contact with a substrate processing apparatus, such as an exposure apparatus or an etching apparatus, or a substrate transfer mechanism, substrates to be transferred and processed by these processing apparatus and transfer mechanisms after the above-described substrate may also be subjected to the metal contamination through the processing apparatus or the transfer mechanism, that is, cross-contamination may occur. Therefore, as disclosed in Patent Documents 2 and 3, methods for forming a protection film to protect a wafer edge and a peripheral edge on a rear surface from a metal-containing material have been reported.

As described above, the method for forming a wafer-edge-protection film is useful in a fine patterning process in semiconductor manufacturing in light of suppressing etching damage in the wafer edge, preventing the wafer edge from metal contamination in processing of metal-containing materials, etc.

On the other hand, in the recent manufacturing of semiconductor devices, processes of forming patterns with an ultra-high aspect ratio on a substrate to be processed have been increasing along with 3D structuring of a device. Although a negative photoresist liquid has been commonly used for the conventional wafer-edge-protection films, because of rapid increases in complication and lengthy processing time of etching processes in manufacturing of advanced devices, it is assumed that a wafer-edge-protection film is desired to have improved etching resistance.

A composition for masking to prevent metal contamination on an edge of substrate in manufacturing an electronic device has been proposed (Patent Document 4). However, the material has insufficient dry etching resistance, and, therefore, there is a demand for a wafer-edge-protection film with higher dry etching resistance.

### CITATION LIST

### PATENT LITERATURE

Patent Document 1: JP2014-110386A
Patent Document 2: JP2014-045171A
Patent Document 3: JP2018-124354A
Patent Document 4: JP2020-514509A

### SUMMARY OF INVENTION

### TECHNICAL PROBLEM

The present invention was made in view of the above circumstances, and has for its object to provide: a composition for forming a wafer-edge-protection film capable of providing a wafer-edge-protection film that can exhibit excellent dry etching resistance superior to conventional wafer-edge-protection films and excellent uniform coatablity, even on a wafer edge that is difficult to be coated; a wafer-edge-protection film forming method using the composition; and a patterning process using the composition.

### SOLUTION TO PROBLEM

To solve the problem above, the present invention provides a composition for forming a wafer-edge-protection film for forming a wafer-edge-protection film on a peripheral edge of a substrate, comprising:
a polymer (A) represented by the following general formula (1); and
a solvent, 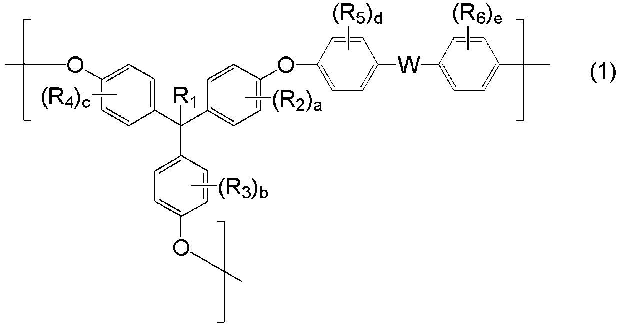
wherein "W" represents -SO₂-, -C(=O)-, or -O-; R₁, R₂, R₃, R₄, and R₅ each independently represent a halogen atom, a monovalent organic group having 1 to 3 carbon atoms, or a hydroxy group; and "a", "b", "c", "d", and "e" each independently represent an integer of 0 to 4.

In such a composition for forming a wafer-edge-protection film, the polymer (A) has a repeating unit having a trifunctional structure of the polymer, and therefore it is possible to form a wafer-edge-protection film with high denseness of a film and excellent dry etching resistance by virtue of exhibition of excellent uniform coatablity even on a wafer edge that is difficult to be coated. Furthermore, the wafer-edge-protection film thus-formed can reliably protect the wafer edge even when a pattern with a high aspect ratio is formed on a substrate to be processed.

Further, the polymer (A) preferably has a weight-average molecular weight of 1,000 to 30,000.

When the polymer (A) has a weight-average molecular weight in this range, outgassing during baking can be reduced without impairing a solubility in a solvent.

Further, the polymer (A) is preferably contained in 10 mass% or more of the composition for forming a wafer-edge-protection film.

By using such a composition for forming a wafer-edge-protection film, it is possible to reliably form a thick edge-protection film even on the wafer edge that is difficult to be coated, and to provide an edge-protection film with a thickness sufficient to withstand a dry etching process of a processed substrate to be processed.

Further, the composition for forming a wafer-edge-protection film preferably further comprises one or more kinds of:
a crosslinking agent;
a surfactant;
an acid generator; and
a plasticizer.

By using a composition for forming a wafer-edge-protection film containing the above additives, it is possible to adjust the various physical properties required when used to form a wafer-edge-protection film, such as defect reduction characteristics, dry etching resistance, and adhesiveness to a substrate, within an appropriate range.

Further, the solvent is preferably a mixture of a high-boiling-point solvent having a boiling point of 180°C or more and a low-boiling-point solvent having a boiling point of less than 180°C.

By including a high-boiling-point solvent with such a boiling point, there is no risk of the solvent evaporating too quickly due to a too low boiling point during baking (heat treatment), therefore sufficient thermal fluidity can be achieved during film formation, and it is possible to form a wafer-edge-protection film with excellent uniform coating even on a wafer edge that is difficult to by coated.

Further, the present invention provides a wafer-edge-protection film forming method for forming a wafer-edge-protection film on a peripheral edge of a substrate, comprising the steps of:
(i) coating a peripheral edge of the substrate with the inventive composition for forming a wafer-edge-protection film to obtain a coating film; and
(ii) curing the coating film by heat or optical irradiation to form the wafer-edge-protection film on the peripheral edge of the substrate.

According to such a wafer-edge-protection film forming method, because the composition to be used contains the polymer (A), being a material for forming a wafer-edge-protection film, represented by the aforementioned general formula (1) having a repeating unit having a trifunctional structure of the polymer, it is possible to form a wafer-edge-protection film that has high denseness of a film and excellent dry etching resistance, can exhibit excellent uniform coatablity even on a wafer edge that is difficult to be coated, and can protect a wafer edge even when a pattern with a high aspect ratio is to be formed on a substrate to be processed.

Further, it is preferable that
in the step (i), in addition to an edge surface on a front surface side of the peripheral edge of the substrate, the composition for forming a wafer-edge-protection film is coated also on an edge surface on a rear surface side of the peripheral edge of the substrate; and
in the step (ii), the wafer-edge-protection film is formed also on the edge surface on the rear surface side of the substrate.

By forming a wafer-edge-protection film, all the way to the edge surface on the rear surface side of the peripheral edge of the substrate, using the inventive composition for forming a wafer-edge protection film, it is possible to avoid the risk of suffering from metal contamination in these areas, i.e., the risk of suffering from metal contamination caused by that a chemical solution supplied onto a front surface of the substrate runs to the peripheral edge on a rear surface of the substrate when forming a metal-containing coating film, resulting in forming a coating film also on an unintended area including the peripheral edge on the rear surface side.

Further, the coating in the step (i) is preferably performed using a spin coating method, so that the wafer-edge-protection film is not formed on areas other than the peripheral edge of the substrate.

By applying the inventive composition for forming a wafer-edge protection film by spin coating to form a wafer-edge protection film only onto the peripheral edge, including the edge surface on the front surface side and the edge surface on the rear surface side, it is possible to greatly contribute to improve the productivity of the semiconductor manufacturing process by virtue of the consumption reduction of chemical solutions, the shortening the manufacturing time, and so on.

Further, in the step (ii), the coating film is preferably cured by heat treatment at a temperature of 100°C or more and 800°C or less for 10 seconds to 7,200 seconds.

By thermally curing, it is possible to form a dense cured film, and the dry etching resistance can be improved.

Further, the present invention provides a patterning process in which a wafer-edge-protection film is formed on a peripheral edge of a substrate to be processed on which a patterned film is formed, and a pattern is formed on the substrate to be processed, comprising the steps of:
(I-1) applying the inventive composition for forming a wafer-edge-protection film onto a peripheral edge of a substrate to be processed on which a patterned film is formed to obtain a coating film;
(I-2) curing the coating film by a heat treatment or optical irradiation to form the wafer-edge-protection film on the peripheral edge of the substrate;
(I-3) forming a pattern on the substrate to be processed by dry etching while using the patterned film as a mask; and
(I-4) removing the wafer-edge-protection film.

The patterning process described above can reliably suppress particle generation from a wafer edge when dry etching the substrate to be processed.

Further, it is preferable that, in the step (I-1), in addition to an edge surface on a front surface side of the peripheral edge of the substrate, the composition for forming a wafer-edge-protection film is applied also onto an edge surface on a rear surface side of the peripheral edge of the substrate; and
in the step (I-2), the wafer-edge-protection film is formed also on the edge surface on the rear surface side of the substrate.

By forming a wafer-edge-protection film, all the way to the edge surface on the rear surface side of the peripheral edge, using the inventive composition for forming a wafer-edge protection film, it is possible to avoid the risk of suffering from metal contamination in these areas, i.e., the risk of suffering from metal contamination caused by that a chemical solution supplied onto the front surface of the substrate runs to the peripheral edge on the rear surface when forming a metal-containing coating film, resulting in forming a coating film also on an unintended area such as these peripheral edge on the rear surface (e.g. the edge surface on the rear surface side).

Further, the present invention provides a patterning process in which a wafer-edge-protection film is formed on a peripheral edge of a substrate to be processed, and a pattern is formed on the substrate to be processed, comprising the steps of:
(II-1) applying the inventive composition for forming a wafer-edge-protection film onto a peripheral edge of a substrate to be processed to obtain a coating film;
(II-2) curing the coating film by heat treatment or optical irradiation to form a wafer-edge-protection film on the peripheral edge of the substrate to be processed;
(II-3) forming a resist upper layer film pattern on the substrate to be processed, and forming a pattern on the substrate to be processed by dry etching while using the resist upper layer film pattern as a mask; and
(II-4) removing the wafer-edge-protection film.

The patterning process described above can suppress particle generation from the wafer edge when dry etching the substrate to be processed. Furthermore, when forming the resist upper layer film, it is possible to avoid the risk that the chemical solution supplied onto the front surface of the substrate runs to the peripheral edge on the rear surface, resulting in forming of a coating film also on the unintended peripheral edge on the rear surface side (e.g. the edge surface on a rear surface side), which would result in contamination of these areas.

Further, it is preferable that
in the step (II-1), in addition to an edge surface on a front surface side of the peripheral edge of the substrate, the composition for forming a wafer-edge-protection film is applied also onto an edge surface on a rear surface side of the peripheral edge of the substrate; and
in the step (II-2), the wafer-edge-protection film is formed also on the edge surface on the rear surface side of the substrate.

By forming a wafer-edge-protection film, all the way to the edge surface on the rear surface side on the rear surface side of the peripheral edge, using the inventive composition for forming a wafer-edge protection film, it is possible to avoid the risk of suffering from metal contamination in these areas, i.e., the risk of suffering from metal contamination caused by that a chemical solution supplied onto the front surface of the substrate runs to the peripheral edge on the rear surface when forming a metal-containing coating film, resulting in forming a coating film also on an unintended area such as these peripheral edge on the rear surface side (e.g. the edge surface on the rear surface side).

### ADVANTAGEOUS EFFECTS OF INVENTION

As described above, according to the inventive composition for forming a wafer-edge-protection film, because the polymer (A) has a repeating unit having a trifunctional structure of polymer, and thus high denseness of a film, it is possible to provide a wafer-edge-protection film that has excellent dry etching resistance superior to conventional wafer-edge-protection film and can exhibit excellent uniform coatablity even on a wafer edge that is difficult to be coated. In particular, even in dry etching processes to form a fine pattern with high aspect ratio, which is represented by those for 3D-NAND memories that have been increasingly highly laminated, the wafer edge can be protected from an etchant until etching of the substrate to be processed is complete and particle generation from the wafer edge due to etching can be reduced. Therefore, the inventive composition for forming a wafer-edge-protection film is extremely useful in a fine patterning process in semiconductor manufacturing.

Furthermore, according to the inventive wafer-edge-protection film forming method, it is possible to provide a wafer-edge-protection film that has excellent dry etching resistance superior to the conventional wafer-edge-protection film and can exhibit excellent uniform coatablity even on a wafer edge that is difficult to be coated. By forming a wafer-edge-protection film also on the surface on the rear surface side of the peripheral edge, it is possible to avoid the risk of suffering from metal contamination in these areas, i.e., the risk of suffering from metal contamination caused by that a chemical solution supplied onto the front surface of a substrate runs to the peripheral edge on the rear surface side when forming a metal-containing coating film, resulting in forming a coating film also on these unintended peripheral edge on the rear surface side.

Furthermore, the inventive patterning process can suppress particle generation from the wafer edge when dry etching the substrate to be processed. Furthermore, when forming the resist upper layer film, it is possible to avoid the risk that the chemical solution supplied onto the front surface of the substrate runs to the peripheral edge on the rear surface, resulting in forming a coating film also on these unintended peripheral edge on the rear surface (e.g. the edge surface on a rear surface side), which would result in contamination of these areas.

### BRIEF DESCRIPTION OF DRAWINGS

FIG. 1 shows explanatory views of some examples of wafer edges;
FIG. 2 shows another explanatory view of a wafer edge;
FIG. 3 shows an explanatory view of an example (protecting a peripheral edge on a front surface side) of the inventive wafer-edge-protection film forming method;
FIG. 4 shows an explanatory view of another example (protecting a peripheral edge on a front surface side and a peripheral edge on a rear surface side) of the inventive wafer-edge-protection film forming method;
FIG. 5 shows an explanatory view of yet another example (protecting a peripheral edge on a front surface side and a peripheral edge on a rear surface side) of the inventive wafer-edge-protection film forming method;
FIG. 6 shows an explanatory view of an example of the inventive patterning process;
FIG. 7 shows an explanatory view of another example of the inventive patterning process;
FIG. 8 shows an explanatory view of evaluation points for the film thickness evaluation of a wafer-edge-protection film; and
FIG. 9 shows an explanatory view of the evaluation method of the quantity of metal impurities on a surface of a peripheral edge.

### DESCRIPTION OF EMBODIMENTS

As described above, a wafer-edge-protection film has been used in the fine patterning process in semiconductor manufacturing in order to prevent particle generation from a wafer edge during etching, and, in recent semiconductor device manufacturing, processes of forming patterns with an ultra-high aspect ratio on a substrate to be processed have been increasing along with 3D structuring of a device. This has arisen a need to form a wafer-edge-protection film that can endure more complex and more lengthy etching processes.

The inventors of the present invention conducted extensive research to solve the above problems and have sought to form a wafer-edge-protection film that provides the film with excellent dry etching resistance and excellent wafer edge coverage in a wafer-edge-protection film forming method. As a result, the inventors found that a wafer-edge-protection film forming method using a composition for forming a wafer-edge-protection film containing a polymer having a repeating unit having a trifunctional structure is very effective and thus completed the present invention.

That is, the present invention is a composition for forming a wafer-edge-protection film for forming a wafer-edge-protection film on a peripheral edge of a substrate, comprising:
a polymer (A) represented by the following general formula (1); and
a solvent, 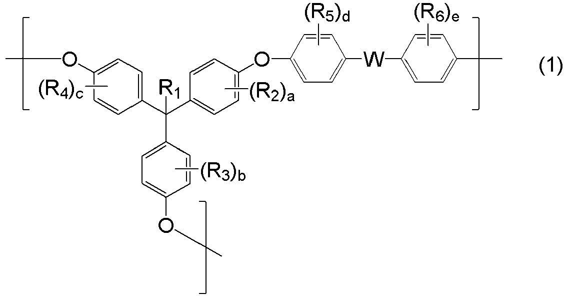
wherein "W" represents -SO₂-, -C(=O)-, or -O-; R₁, R₂, R₃, R₄, and R₅ each independently represent a halogen atom, a monovalent organic group having 1 to 3 carbon atoms, or a hydroxy group; and "a", "b", "c", "d", and "e" each independently represent an integer of 0 to 4.

Hereinafter, the present invention will be described in detail. However, the present invention is not limited thereto.

### <Composition for Forming Wafer-Edge-Protection Film >

The inventive composition for forming a wafer-edge-protection film contains a polymer (A) represented by the following general formula (1) and a solvent, 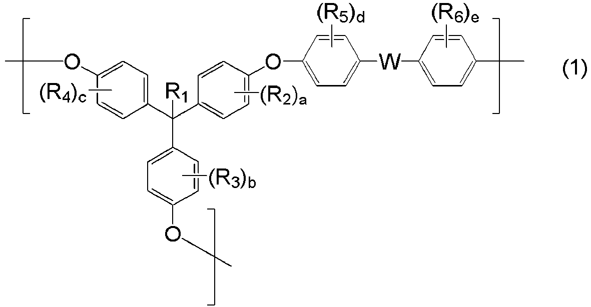 wherein "W" represents -SO₂-, -C(=O)-, or -O-; R₁, R₂, R₃, R₄, and R₅ each independently represent a halogen atom, a monovalent organic group having 1 to 3 carbon atoms, or a hydroxy group; and "a", "b", "c", "d", and "e" each independently represent an integer of 0 to 4.

Hereinafter, the polymer (A) and the solvent contained in the inventive composition for forming a wafer-edge-protection film will be described in detail.

### [(A) Polymer]

Since the polymer (A) is represented by the general formula (1), i.e., contains the repeating unit represented by the general formula (1), it has a repeating unit having a trifunctional structure of the polymer. Therefore, it is possible to form a wafer-edge-protection film having high denseness of a film and excellent dry etching resistance. Such a wafer-edge-protection film can protect a wafer edge even when a pattern with a high aspect ratio is formed on a substrate to be processed.

In the above general formula (1), R₁, R₂, R₃, R₄, and R₅ each independently represent a halogen atom, a monovalent organic group having 1 to 3 carbon atoms, or a hydroxy group, and "a", "b", "c", "d", and "e" each independently represent an integer of 0 to 4. From the viewpoint of dry etching resistance, "a", "b", "c", "d", and "e" each are preferably 0.

In the above general formula (1), when R₁, R₂, R₃, R₄ and R₅ are monovalent organic groups having 1 to 3 carbon atoms, examples thereof include a methyl group, an ethyl group and a propyl group.

The weight-average molecular weight of the polymer (A) above is preferably 1,000 to 30,000, more preferably 2,000 to 15,000.

When the polymer (A) has a molecular weight range within such a range, solubility in a solvent can be ensured and sublimate generation during baking can be suppressed. That is, outgassing can be suppressed. Furthermore, the composition for forming a wafer-edge protection film has good thermal fluidity, and thus, when incorporated into a material, it is possible to provide the composition for forming a wafer-edge-protection film having better wafer edge coverage and better defect reduction characteristics.

The inventive composition for forming a wafer-edge-protection film preferably contains the polymer (A) in an amount of 10 mass% or more, more preferably 15 mass% or more, and further preferably 20 mass% or more.

Even in a dry etching process for forming fine patterns with an ultra-high aspect ratio on a substrate to be processed, it is necessary to have a thick wafer-edge-protection film formed in order to protect a wafer edge from an etchant until etching of the substrate to be processed is completed. When the composition for forming a wafer-edge-protection film contains the polymer (A) in such an amount, it is possible to form a thick wafer-edge-protection film according to the required characteristics.

### [Method for Manufacturing Polymer (A)]

Methods for obtaining the polymer (A) contained in the inventive composition for forming a wafer-edge-protection film include synthesis via a substitution reaction between phenols and aryl halides using a base catalyst, as shown below. For the phenols and the aryl halides used in the synthesis, one thereof each can be used alone, or two or more kinds thereof may be used in combination. These may be appropriately selected and combined according to the required characteristics. In the following formula, "W", R₁, R₂, R₃, R₄, R₅, "a", "b", "c", "d", and "e" represent the same as those defined above, and "X" represents a halogen atom.

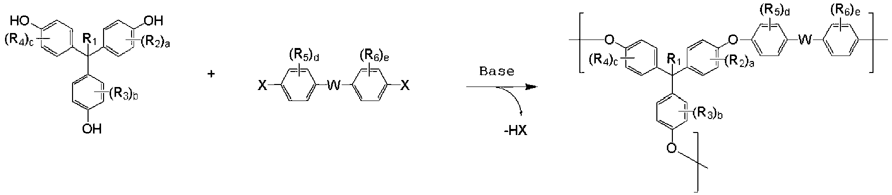

Examples of the base catalyst used in this case include inorganic base compounds, such as sodium hydrogen carbonate, sodium carbonate, potassium carbonate, calcium carbonate, cesium carbonate, sodium hydroxide, potassium hydroxide, sodium hydride, and potassium phosphate; and organic amine compounds, such as triethylamine, pyridine, and N-methylmorpholine. One of these may be used, or two or more kinds thereof may be used in combination. The amount of these catalysts used is preferably in the range of 0.1 to 20 mol, more preferably 0.2 to 10 mol, per mol of hydroxy groups in phenols as raw material.

The solvent used in this case is not particularly limited as long as it is inert to the above reaction, and examples thereof include ether solvents, such as diethyl ether, tetrahydrofuran, and dioxane; aromatic solvents, such as benzene, toluene, and xylene; acetonitrile; dimethyl sulfoxide; N,N-dimethylformamide; N-methylpyrrolidone; and water. One kind of these may be used, or these may be used in a mixture thereof. These solvents may be used in an amount ranging from 0 to 2000 parts by mass based on 100 parts by mass of raw materials for the reaction. The reaction temperature is preferably from -50°C to the boiling point of the solvent, more preferably from room temperature to 150°C. The reaction time is appropriately selected from the range of 0.1 to 100 hours. In this specification, the boiling point of a solvent refers to the boiling point at the standard atmospheric pressure (1 atm = 1013.25 hPa).

Examples of the reaction method include: a method in which phenol(s) and aryl halide(s) are charged all at once in a solvent; a method in which phenol(s) and aryl halide(s) are charged individually or as a mixture, and then each or the mixture is dispersed or dissolved and charged dropwise; and a method in which either phenol(s) or aryl halide(s) is dispersed or dissolved in a solvent, and then the other dispersed or dissolved in another solvent is charged dropwise. In addition, when a plurality of phenols and a plurality of aryl halides are charged, they may be mixed and reacted in advance, or they may be reacted separately and sequentially. When a base catalyst is used, examples of the reaction method include: a method in which the base catalyst, phenol(s), and aryl halide(s) are charged all at once; and a method in which the base catalyst is dispersed or dissolved in advance and then phenol(s) and aryl halide(s) is added dropwise to the resultant dispersion or solution.

The resulting reaction liquid may be diluted with an organic solvent to remove unreacted raw materials, catalysts, etc. present in the system, and then recovered by liquid-liquid separation and washing.

The organic solvent used for the liquid-liquid separation and washing is not particularly limited as long as it can dissolve the phenols and the aryl halides and separate into two layers when mixed with water. Examples of the organic solvent include: hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl tert-butyl ether, ethyl cyclopentyl methyl ether, and tetrahydrofuran; chlorinated solvents, such as methylene chloride, chloroform, dichloroethane, and trichloroethylene; and mixtures thereof. The washing water to be used in this case is usually those called "deionized water" or "ultrapure water". The number of washings may be one or more times, but washing ten or more times does not necessarily provide effect commensurate with that, so washing is preferably about one to five times.

In order to remove unreacted raw materials or acidic components from the system during the liquid-liquid separation and washing, washing may be performed with a basic aqueous solution. Specific examples of the base include alkali metal hydroxides, alkali metal carbonates, alkaline earth metal hydroxides, alkaline earth metal carbonates, ammonia, and organic ammonium.

Furthermore, in order to remove unreacted materials, metal impurities, or basic components from the system during liquid-liquid separation and washing, the washing may be performed with an acidic aqueous solution. Specific examples of the acid include: inorganic acids, such as hydrochloric acid, hydrobromic acid, sulfuric acid, nitric acid, phosphoric acid, and heteropolyacid; and organic acids, such as oxalic acid, fumaric acid, maleic acid, trifluoroacetic acid, methanesulfonic acid, benzenesulfonic acid, p-toluenesulfonic acid, and trifluoromethanesulfonic acid.

The above-mentioned washing with a basic aqueous solution and the liquid-liquid separation and washing with an acidic aqueous solution may be carried out either alone or in combination. From the viewpoint of removing metal impurities, the liquid-liquid separation and washing is preferably carried out in the order of the basic aqueous solution and the acidic aqueous solution.

After the liquid-liquid separation and washing with the basic aqueous solution and/or acidic aqueous solution, washing with neutral water may be performed successively. As the neutral water, deionized water, ultrapure water, or the like, as described above, may be used. The number of washings may be one or more, but the basic and acidic components may not be removed when the number of washings is too small. Washing ten or more times does not necessarily provide effect commensurate with that, so washing is preferably about one to five times.

Furthermore, the reaction product after the separation operation can be recovered as a powder by concentrating the solvent to dryness or crystallizing it under reduced or normal pressure. However, in order to improve operability when preparing a composition for forming a wafer-edge protection film, it may also be left in a solution state with an appropriate concentration. The concentration in this case is preferably 0.1 to 50 mass%, more preferably 0.5 to 30 mass%. At such a concentration, the viscosity hardly increases, preventing a loss of operability, and the amount of solvent is not excessive, making it economical.

The solvent used in this case is not particularly limited as long as it can dissolve the compound. Specific examples include: ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One kind of these may be used, or two or more kinds thereof may be used in a mixture.

In the above reaction, phenols and aryl halides may be combined according to the required performance. Specifically, compounds incorporating a substituent that contribute to solubility in a solvent, etching resistance, and thermal fluidity according to the desired performance requirements can be used. Compositions for forming a wafer-edge-protection film using these compounds as raw materials for the polymer (A) can achieve both etching resistance and thermal fluidity at high level.

### [(B) Solvent]

The solvent (organic solvent) that can be used for the composition for forming a wafer-edge-protection film described above is not particularly limited as long as the solvent can dissolve the polymer (A) described above. The solvent is preferably capable of also dissolving a crosslinking agent, a surfactant, an acid generator, and a plasticizer, which are described later.

Specifically, for example, solvents described in paragraphs [0091] to [0092] of JP2007-199653A may be added as a solvent. Furthermore, specifically, propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more kinds thereof are preferably used.

The blending amount of the solvent is preferably adjusted according to determined thickness of a wafer-edge-protection film. The blending amount is usually in the range of 100 to 50,000 parts by mass based on 100 parts by mass of the polymer (A).

Furthermore, in the composition for forming a wafer-edge protection film, the solvent may contain a high-boiling-point solvent having a boiling point of 180°C or higher at standard pressure. In this case, the solvent contained in the composition may be a mixture of one or more solvents having a boiling point of less than 180°C (hereinafter also referred to as "low-boiling-point solvents") and one or more solvents having a boiling point of 180°C or higher (hereinafter also referred to as "high-boiling-point solvents").

Specific examples of the low-boiling-point solvent include propylene glycol monomethyl ether acetate, propylene glycol monomethyl ether, propylene glycol monoethyl ether, propylene glycol monopropyl ether, 2-heptanone, cyclopentanone, and cyclohexanone.

The high-boiling-point solvent may be any solvent that can dissolve each component of the inventive composition for forming a wafer-edge-protection film, and is not limited to those such as hydrocarbons, alcohols, ketones, esters, ethers, and chlorinated solvents. Specific examples of the high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, and dibutyl adipate. One kind of these may be used, or two or more kinds thereof may be used as a mixture.

The high-boiling-point solvent may be appropriately selected, for example, from the above solvents, according to the temperature at which the above composition for forming a wafer-edge-protection film is subjected to the heat treatment, and the like. The boiling point of the high-boiling-point solvent is preferably 180°C to 300°C, more preferably 200°C to 300°C. With such a boiling point, there is no risk of excessively rapid volatilization during baking (heat treatment) due to an excessively low boiling point. It is therefore considered that sufficient thermal flowability can be obtained during the film formation, and that a wafer-edge-protection film with excellent uniform coatability can be formed even on a wafer edge that is difficult to be coated. Furthermore, with the solvent having such a boiling point, it is possible to prevent the risk of not being evaporated after baking due to the too high boiling point and remaining in the film, and thus physical properties of the film, such as etching resistance is not adversely affected.

When the high boiling point solvent is used, the blending amount thereof is preferably 1 to 200 parts by mass, more preferably 1 to 100 parts by mass, based on 100 parts by mass of the polymer (A). With such a range of blending amount, there is no risk of insufficient thermal flowability at baking due to an excessively small blending amount, and also there is no risk of leading to degradation of physical properties of the film, such as etching resistance, due to residual solvent in the film caused by an excessively large blending amount. Thus, such a blending amount is preferable.

In addition to the polymer (A) and the solvent (B), the inventive composition for forming a wafer-edge-protection film may further, as an optional component, contain one or more kinds of:
a crosslinking agent;
a surfactant;
an acid generator; and
a plasticizer.

These optional components are described below.

### [(C) Crosslinking Agent]

A crosslinking agent may also be added to the composition for forming a wafer-edge protection film to enhance curability resulting in improvement of dry etching resistance. The crosslinking agent is not particularly limited, and a wide variety of publicly known crosslinking agents can be used. Examples of the crosslinking agent include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (for example, methylol or alkoxymethyl crosslinking agents of polynuclear phenols). When a crosslinking agent is added, the blending amount is preferably 5 to 100 parts by mass, more preferably 10 to 50 parts by mass, based on 100 parts by mass of the polymer (A).

Specific examples of melamine-based crosslinking agents include hexamethoxymethylated melamine, hexabutoxymethylated melamine, alkoxy- and/or hydroxy-substituted derivatives thereof, and partial self-condensates thereof. Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof. Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof. Specific examples of the urea-based crosslinking agents include dimethoxymethylated dimethoxyethylene urea, alkoxy and/or hydroxy-substituted derivatives thereof, and partial self-condensates thereof. Specific examples of the β-hydroxyalkylamide-based crosslinking agents include N,N,N',N'-tetra(2-hydroxyethyl)adipamide. Specific examples of the isocyanurate-based crosslinking agents include triglycidyl isocyanurate and triallyl isocyanurate. Specific examples of the aziridine crosslinking agent include 4,4'-bis(ethyleneiminocarbonylamino)diphenylmethane and 2,2-bishydroxymethylbutanol-tris[3-(1-aziridinyl)propionate]. Specific examples of the oxazoline crosslinking agent include 2,2'-isopropylidenebis(4-benzyl-2-oxazoline), 2,2'-isopropylidenebis(4-phenyl-2-oxazoline), 2,2'-isopropylidenebis(4-phenyl-2-oxazoline), 2,2'-methylenebis-4,5-diphenyl-2-oxazoline, 2,2'-methylenebis-4-phenyl-2-oxazoline, 2,2'-methylenebis-4-tertbutyl-2-oxazoline, 2,2'-bis(2-oxazoline), 1,3-phenylenebis(2-oxazoline), 1,4-phenylenebis(2-oxazoline), and 2-isopropenyloxazoline copolymer. Specific examples of the epoxy crosslinking agent include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (C-2).

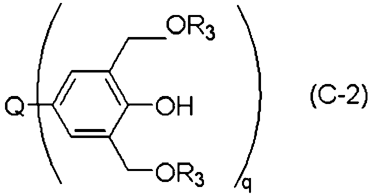

In the formula, "Q" represents a single bond or a q-valent hydrocarbon group having 1 to 20 carbon atoms; R₃ represents a hydrogen atom or a methyl group; and "q" represents an integer of 1 to 5. The definitions of the symbols in the formula apply only to this formula.

In the general formula (C-2), Q represents a single bond or a q-valent hydrocarbon group having 1 to 20 carbon atoms. "q" is an integer of 1 to 5, and more preferably 2 or 3. When "Q" is a q-valent hydrocarbon group having 1 to 20 carbon atoms, "Q" is a q-valent hydrocarbon group obtained by removing q hydrogen atoms from a hydrocarbon having 1 to 20 carbon atoms. More specific examples of the hydrocarbons having 1 to 20 carbon atoms in this case include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane.

R₃ in the general formula (C-2) represents a hydrogen atom or a methyl group and is preferably a methyl group.

Containing the compound represented by the formula (C-2) as a crosslinking agent increases crosslinking reactivity of the hydroxy groups contained in the polymer (A), and it is possible to improve denseness of a film. Thus, it is possible to further improve the heat resistance characteristic of the composition for forming a wafer-edge-protection film.

Specific examples of the compound represented by the general formula (C-2) include, but are not limited to, the following compounds. In the formulae below, R₃ represents the same as defined above. From the viewpoints of curability, improved film thickness uniformity, and reduced sublimates, it is preferable to satisfy q=3 and R₃=methyl group, and in particular, hexamethoxymethylated products of triphenolmethane, triphenolethane, 1,1,1-tris(4-hydroxyphenyl)ethane, or tris(4-hydroxyphenyl)-1-ethyl-4-isopropylbenzene are preferable.

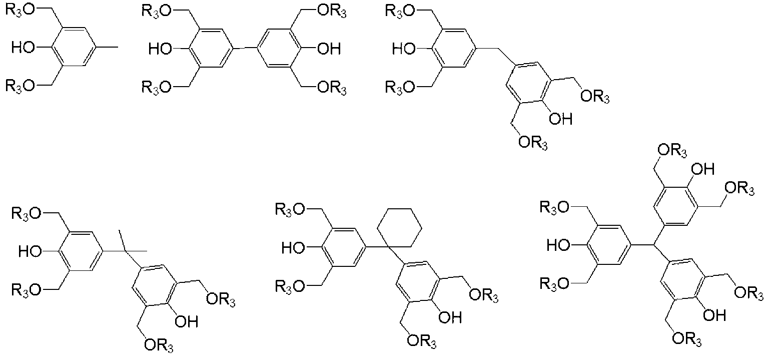

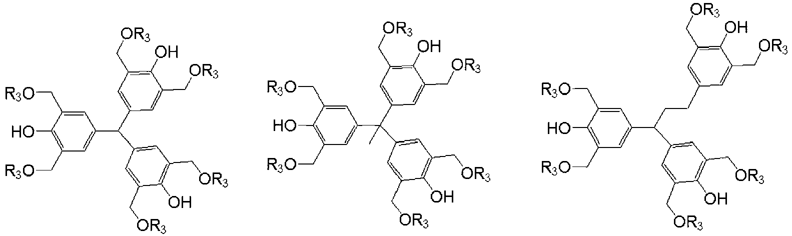

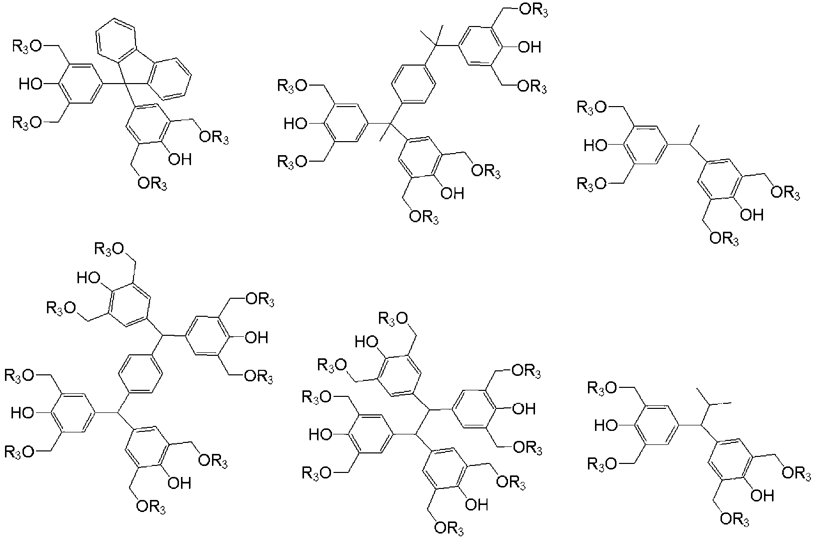

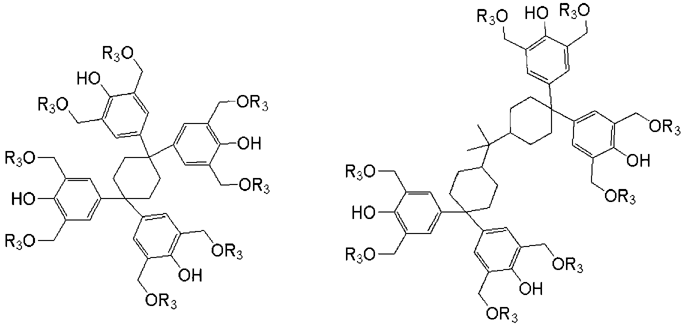

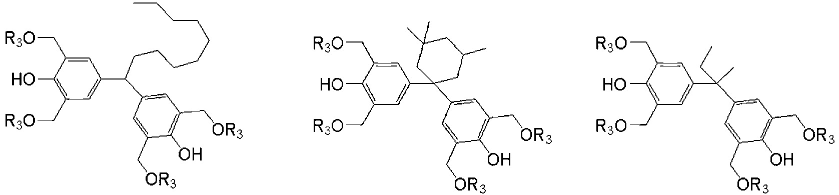

One kind of the crosslinking agent may be used, or two or more kinds thereof may be used in combination. The crosslinking agent is preferably contained in 5 to 100 mass%, more preferably 10 to 50 mass%, based on 100 mass% of the polymer (A). With addition of the crosslinking agent in 5 mass% or more, the crosslinking reaction with the polymer (A) can be accelerated to form a dense film with excellent curability, thereby it is possible to form a wafer-edge-protection film that is favorable in heat resistance, dry etching resistance, and film thickness uniformity. On the other hand, addition of 100 mass% or less can suppress the generation of sublimates due to slowing of the crosslinking reaction between the polymer (A) and the crosslinking agent (C), thereby reducing the generation of sublimates and deterioration of film thickness uniformity.

### [(D) Surfactant]

A surfactant (D) may be added to the composition for forming a wafer-edge-protection film in order to improve coatability in spin coating. Specific examples of the surfactant to be used include those disclosed in paragraphs [0142] to [0147] of JP2009-269953A. When the surfactant is added, the addition amount is preferably 0.001 to 20 parts by mass, more preferably 0.01 to 10 parts by mass, based on 100 parts by mass of the polymer (A) .

### [(E) Acid Generator]

An acid generator (E) may be added to the composition for forming a wafer-edge-protection film in order to further promote the curing reaction. The acid generator can be classified into those that is to generate an acid by thermal decomposition and those that is to generate an acid by optical irradiation, but any acid generator can be added. Specific examples of the acid generator include, but not limited to, those disclosed in paragraphs [0061] to [0085] of JP2007-199653A.

One kind of the above acid generators may be used, or two or more kind thereof may be used in combination. When the acid generator is added, the addition amount is preferably 0.05 to 50 parts by mass, more preferably 0.1 to 10 parts by mass, based on 100 parts by mass of the polymer (A).

### [(F) Plasticizer]

Further, a plasticizer (G) may be added to the composition for forming a wafer-edge-protection film to further improve film-formability on the wafer edge. The plasticizer is not particularly limited, and various publicly known plasticizers can be widely used. Examples of the plasticizer include low-molecular-weight compounds, such as phthalate esters, adipate esters, phosphate esters, trimellitate esters, and citrate esters; and polymers, such as polyether-based polymers, polyester-based polymers, and polyacetal-based polymers disclosed in JP2013-253227A. When the plasticizer is added, the addition amount is preferably 5 to 500 parts by mass, more preferably 10 to 200 parts by mass, based on 100 parts by mass of the polymer (A).

### [Other Additives]

Further, in addition to the described-above optional components, an additive to further improve the film-formability on the wafer edge may be added to the composition for forming a wafer-edge-protection film. The additive is not particularly limited as long as the additive contributes to improvement in thermal flowability and imparts film-formability on a wafer edge to the composition. For example, the additives to be preferably used are liquid additives having a structure of polyethylene glycol or polypropylene glycol or thermally decomposable polymers having a weight reduction ratio of 40 mass% or more while the temperature is changed from 30°C to 250°C and a weight-average molecular weight of 300 to 200,000. The thermally decomposable polymers preferably contain a repeating unit having an acetal structure represented by the following general formula (DP1) or (DP1a).

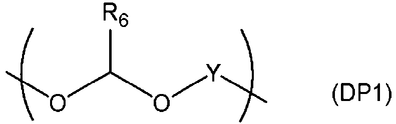

In the formula, R₆ represents a hydrogen atom or a saturated or unsaturated monovalent organic group having 1 to 30 carbon atoms and optionally being substituted; and "Y" represents a saturated or unsaturated divalent organic group having 2 to 30 carbon atoms. The definitions of the symbols in the formula apply only to this formula.

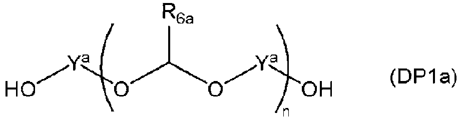

In the formula, R₆ₐ represents an alkyl group having 1 to 4 carbon atoms; Y^{a} is a saturated or unsaturated divalent hydrocarbon group having 4 to 10 carbon atoms and optionally having an ether bond; and "n" represents the average number of repeating units and is 3 to 500.

According to the inventive composition for forming a wafer-edge-protection film described above, the polymer (A) has a repeating unit having a trifunctional structure of the polymer, and therefore it is possible to form a wafer-edge-protection film with high denseness of a film and excellent dry etching resistance by virtue of exhibition of excellent uniform coatablity even on a wafer edge that is difficult to be coated. Furthermore, the wafer-edge-protection film formed in this manner can reliably protect the wafer edge even when a pattern with a high aspect ratio is formed on a substrate to be processed.

### <Wafer-Edge-Protection Film Forming Method>

In the inventive wafer-edge-protection film forming method of the present invention, in general, the inventive composition for forming a wafer-edge-protection film for forming a protection film is applied onto a peripheral edge (wafer edge) of a substrate onto the peripheral edge of the substrate so as to form a wafer-edge-protection film on the peripheral edge of the substrate.

Specifically, the present invention provides a wafer-edge-protection film forming method for forming a wafer-edge-protection film on a peripheral edge of a substrate, comprising the steps of:
(i) coating a peripheral edge of the substrate with the inventive composition for forming a wafer-edge-protection film to obtain a coating film; and
(ii) curing the coating film by heat or optical irradiation to form the wafer-edge-protection film on the peripheral edge of the substrate.

According to this wafer-edge-protection film forming method, the inventive composition for forming a wafer-edge-protection film is used, so that it is possible to form a wafer-edge-protection film that can endure more complex and more lengthy etching processes.

The substrate is not particularly limited, and a substrate of Si, α-Si, p-Si, SiO₂ , SiN, SiON, W, TiN, Al, or the like, a substrate having a layer to be processed formed thereon as a film, etc. are used as the substrates. Examples of the layer to be processed include: films of various low-k materials, such as Si, SiO₂, SiON, SiN, p-Si, α-Si, W, W-Si, Al, Cu, and Al-Si; stopper films thereof; Hf, Zr, Cr, Ge, Ag, Au, In, Ga, As, Pd, Fe, Ta, Co, Mn, Mo, Ru, or alloys thereof; amorphous carbon; organic resist underlayer films; silicon-containing resist middle layer films; and hard masks, such as inorganic hard masks. These may be typically formed to have a thickness of 50 to 10,000 nm, particularly 100 to 5,000 nm. When forming a layer to be processed, the substrate and the layer to be processed are made of different materials.

As shown in FIG. 2, the peripheral edge 1E of the substrate 1 is preferably within 15 mm, more preferably within 10 mm, and particularly preferably within 5 mm from the apex 1a, which is an outmost peripheral edge of the substrate 1, for example. In this specification, the peripheral edge (wafer edge) 1E of the substrate refers to a portion including the edge surface 1b on the front surface side, the bevel 1c, and the apex 1a, as shown in Fig. 1. In addition, the peripheral edge (wafer edge) 1E of the substrate may further include the rear surface 1e (edge surface on a rear surface side) of the edge and the bevel 1d. In this case, the portion including the edge surface 1b on the front surface side and the bevel 1c is also referred to as the peripheral edge on the front surface side, and the portion including the edge surface 1e on the rear surface side and the bevel 1d is also referred to as the peripheral edge on the rear surface side.

The wafer-edge-protection film forming method using the inventive composition for forming a wafer-edge-protection film can form a wafer-edge-protection film on the peripheral edge on the front surface side of the substrate, for example, by applying the inventive composition for forming a wafer-edge-protection film onto the peripheral edge on the front surface side of the substrate.

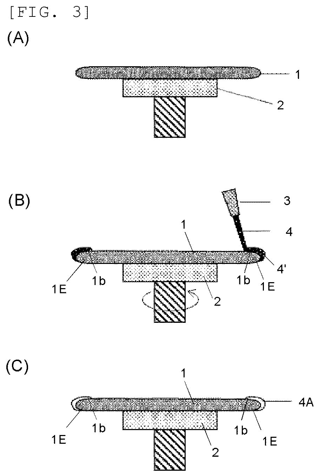

As shown in FIG. 3 (A), in the step (i), a wafer (substrate) 1 is placed on a rotatable spin chuck 2 at first. The method for applying the inventive composition for forming a wafer-edge-protection film onto the substrate 1 is not particularly limited, but any appropriate application method can be used, such as a spin coating method in which a coating solution is continuously discharged onto the substrate 1 rotating at a constant speed, a spray method in which a coating solution is sprayed onto the surface of the substrate 1, or the like. In this embodiment, the spin coating method is used to apply the composition for forming a wafer-edge-protection film onto the edge surface 1b on the front surface side of the peripheral edge of the wafer 1. Specifically, as shown in FIG. 3 (B), the spin chuck 2 is rotated at a rotation speed corresponding to the viscosity of the composition 4 for forming a wafer-edge-protection film and the desired coating thickness, and the edge surface 1b on the front surface side of the peripheral edge 1E of the wafer 1 is coated with the composition 4 for forming a wafer-edge-protection film, thereby obtaining a coating film 4'. For example, as shown in FIG. 3 (B), the composition 4 for forming a wafer-edge-protection film is discharged from the tip of the supply nozzle 3 for supplying the composition 4 for forming a wafer-edge protection film from above onto the edge surface 1b on the front surface side of the peripheral edge 1E of the wafer 1 rotating around its vertical axis in a horizontal plane. Subsequently, in the step (ii), the coating film 4' is cured by heat or light irradiation to form a wafer-edge protection film 4A on the edge surface 1b on the front surface side of the peripheral edge 1E, as shown in FIG. 3(C).

It should be noted that the inventive wafer-edge-protection film forming method may be a method of forming a wafer-edge-protection film on a peripheral edge (wafer edge) of a substrate to be processed on which a resist upper layer film pattern has been formed, or a method in which a wafer-edge-protection film is formed on a substrate to be processed, and then the application of a resist upper layer film is performed and the exposure or the like are performed to form a resist upper layer film pattern. Alternatively, the method may be a method of forming a resist upper layer film pattern according to a multilayer resist method typified by a 3-layer resist process, in which a wafer-edge protection film is formed on a substrate to be processed, and then a resist underlayer film, an inorganic hard mask, etc., are formed thereon; and a resist upper layer film is formed thereon. Since the substrate to be processed is processed while using the patterned resist upper layer film as a mask, if a wafer-edge protection film can be formed on the wafer edge using a composition for forming a wafer-edge protection film before dry etching begins, it is preferable because particle generation from the wafer edge can be suppressed.

It should be noted that when the inventive composition for forming a wafer-edge-protection film is applied onto the peripheral edge of a substrate, the coating film may be dried by rotating the spin chuck, for example, at 10 to 4000 rpm, after application.

Furthermore, in the inventive wafer-edge-protection film forming method, it is also possible to form a wafer-edge-protection film on the edge surface on the front surface side and the edge surface on the rear surface side of the peripheral edge of the substrate (the peripheral edge on the front surface side and the peripheral edge on the rear surface side) by applying the composition for forming a wafer-edge-protection film onto the edge surface on the front surface side and the edge surface on the rear surface side of the peripheral edge of the substrate.

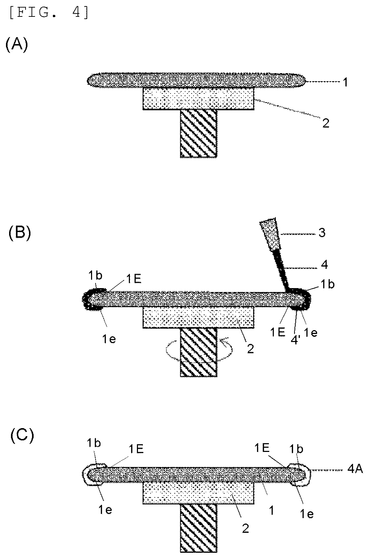

In this example, as shown in FIG. 4 (A), in the step (i), a wafer (substrate) 1 is placed on a rotatable spin chuck 2 at first. The method for applying the inventive composition for forming a wafer-edge-protection film onto the substrate is not particularly limited, but any appropriate application method can be used, for example such as a spin coating method in which a coating solution of the composition for forming a wafer-edge-protection film is continuously discharged onto the substrate 1 rotating at a constant speed, a spray method in which a coating solution is sprayed onto the surface of the substrate, or the like. In this embodiment, the spin coating method is used to apply the composition 4 for forming a wafer-edge-protection film onto the edge surface 1b on the front surface side and the edge surface 1e on the rear surface side of the peripheral edge 1E of the wafer 1. Specifically, as shown in FIG. 4 (B), while the spin chuck 2 is rotated at a rotation speed corresponding to the viscosity of the composition 4 for forming a wafer-edge-protection film and the desired coating thickness, the edge surface 1b on the front surface side and the edge surface 1e on the rear surface side of the peripheral edge 1E of the wafer 1 are coated with the composition 4 for forming a wafer-edge-protection film, thereby obtaining a coating film 4'. More specifically, as shown in FIG. 4 (B), the composition 4 for forming a wafer-edge-protection film is discharged from the tip of the supply nozzle 3 for supplying the composition 4 for forming a wafer-edge-protection film from above onto the edge surface 1b on the front surface side and the edge surface 1e on the rear surface side of the peripheral edge 1E of the wafer 1 rotating around its vertical axis in a horizontal plane. Subsequently, in the step (ii), the coating film 4' is cured by heat or light irradiation to form a wafer-edge protection film 4A on the edge surface 1b on the front surface side and the edge surface 1e on the rear surface side of the peripheral edge 1E, as shown in FIG. 4 (C).

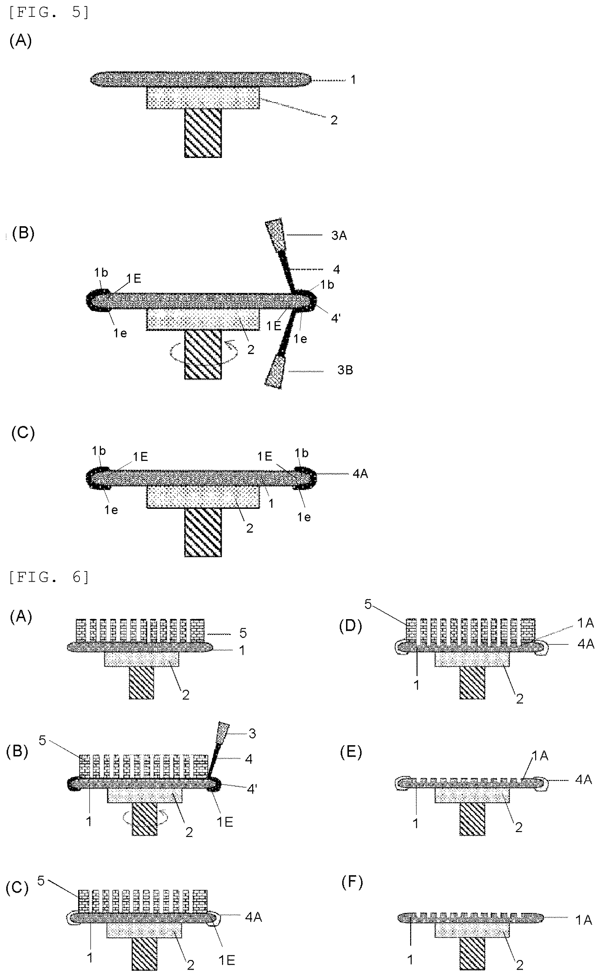

It should be noted that when applying the composition onto the edge surface on the front surface side and the edge surface on the rear surface side of the peripheral edge of the substrate, the composition for forming a wafer-edge-protection film may be supplied from separate supply nozzles to the peripheral edge on the front surface side and the peripheral edge on the rear surface side, respectively. For example, in the embodiment shown in FIG. 5, the wafer 1 is placed on the spin chuck 2 as shown in FIG. 5 (A); the composition 4 for forming a wafer-edge-protection film is discharged from the tip of the upper supply nozzle 3A and the lower supply nozzle 3B for supplying the composition 4 for forming a wafer-edge-protection film from above and below onto the edge surface 1b on the front surface side and the edge surface 1e on the rear surface side of the peripheral edge 1E of the rotating wafer 1, as shown in FIG. 5 (B); and the wafer-edge-protection films 4A are formed on the front surface side and on the rear surface side of the peripheral edge 1E, as shown in FIG. 5 (C). After coating, the coating film 4' may be dried by rotating the spin chuck 2, for example, at 10 to 4000 rpm.

The lower limit of the average film thickness of the wafer-edge-protection film is preferably 100 nm, more preferably 200 nm, for the portion covering the edge surface on the front surface side. It is preferably 100 nm, more preferably 200 nm, for the portion covering the bevel. It is preferably 200 nm, more preferably 300 nm, for the portion covering the apex. It is preferably 1 nm, more preferably 5 nm.

The upper limit of the average film thickness of the wafer-edge-protection film is preferably 5,000 nm, more preferably 4,000 nm, for the portion covering the edge surface on the front surface side. It is preferably 5,000 nm, more preferably 4,000 nm, for the portion covering the bevel. It is preferably 7,000 nm, more preferably 6,000 nm, for the portion covering the apex. It is preferably 1,000 nm, more preferably 500 nm, for the portion covering the edge surface on the rear surface side.

The thickness of the wafer-edge-protection film may be selected appropriately depending on the purpose of edge protection, but as long as it is within the above range, it is possible to provide a method for forming a wafer-edge-protection film that can endure more complex and more lengthy etching processes, which is represented by a process of forming a pattern with an ultra-high aspect ratio.

In the inventive wafer-edge protection film forming method, the wafer-edge protection film is preferably formed only on the peripheral edge (including the edge surface on the front surface side and the edge surface on the rear surface side) of the substrate, which can contribute to rationalization of the semiconductor manufacturing process, such as reducing the amount of chemicals consumed for the composition for forming a wafer-edge protection film and simplifying a protective film formation process and a protective film removing process.

In the inventive wafer-edge-protection film forming method, in the step (ii), the coating film of the composition for forming a wafer-edge-protection film, which is applied to the peripheral edge of the substrate, is cured by heat or light irradiation. In particular, thermal curing is preferable from the viewpoint of dry etching resistance.

When the coating film applied onto the peripheral edge of the substrate is thermally cured, the coating film is preferably cured by heat-treating the coating film at a temperature of 100°C and higher and 800°C or lower, preferably 150°C and higher and 600°C or lower, for 10 to 7,200 seconds, preferably 10 to 600 seconds, to form a wafer-edge protection film. From the viewpoint of reducing sublimates in the composition for forming a wafer-edge-protection film, the heat treatment is performed more preferably at a temperature of 100°C or higher and 450°C or lower, and the heat treatment is performed more preferably at for 10 to 300 seconds from the viewpoint of productivity.

Heat treatment within the above temperature range is preferable because it is possible to form a wafer-edge-protection film with excellent dry etching resistance, and also because when coating material such as a photoresist is applied onto the substrate to be processed on which the wafer-edge-protection film has been formed, problems such as mixing of a wafer-edge-protection film with a resist film and peeling of a protective film due to an edge-cut rinse such as PGMEA do not occur.

When the composition for forming a wafer-edge-protection film applied onto the peripheral edge of the substrate is cured by light irradiation, the light used for curing is not particularly limited, and examples thereof include light or radiation having the same range of wavelengths as those of high-energy ionizing radiation, near ultraviolet light, far ultraviolet light, visible light, infrared light, etc. As the radiation, for example, microwaves, EUV, LED, semiconductor laser light, or laser light used for fine processing of optical semiconductors, such as 248 nm KrF excimer laser beam or 193 nm ArF excimer laser beam, can be suitably used.

These lights may be monochrome lights or lights (mixed light) with multiple different wavelengths. The wavelength of the light may be, for example, about 150 to 800 nm, preferably about 150 to 600 nm, and more preferably about 150 to 400 nm. The irradiation light quantity (irradiation energy) is not particularly limited and may be, for example, about 1 to 10,000 mW, preferably about 5 to 5,000 mW, and more preferably about 10 to 1,000 mW. The irradiation time is also not particularly limited and may be, for example, about 5 seconds to 60 minutes, preferably about 10 seconds to 30 minutes, and more preferably about 30 seconds to 10 minutes.

It should be noted that the heat treatment and the light irradiation may be combined.

In coating the peripheral edge (wafer edge), it is more difficult to form a uniform film when compared to coating the wafer surface, and therefore the composition for forming a wafer-edge-protection film is required to have excellent film-formability. On the other hand, the inventive wafer-edge-protection film forming method uses a composition for forming a wafer-edge-protection film containing the polymer (A) represented by the above general formula (1) to protect the peripheral edge of the substrate to be processed, making it possible to repair film roughness that occurs during coating by thermal flow, and thus providing a wafer-edge-protection film forming method giving excellent uniform coatability.

### <Patterning Process>

As the patterning process according to the first embodiment, the present invention provides a patterning process in which a wafer-edge-protection film is formed on a peripheral edge of a substrate to be processed on which a patterned film is formed and a pattern is formed on the substrate to be processed, comprising the steps of:
(I-1) applying the composition for forming a wafer-edge-protection film according to the present invention onto a peripheral edge of a substrate to be processed on which a patterned film is formed to obtain a coating film;
(I-2) curing the coating film by a heat treatment or optical irradiation to form the wafer-edge-protection film on the peripheral edge of the substrate;
(I-3) forming a pattern on the substrate to be processed by dry etching while using the patterned film as a mask; and
(I-4) removing the wafer-edge-protection film.

An example of the inventive patterning process according to the first embodiment is specifically explained below using FIG. 6. First, in the step (I-1), a substrate to be processed 1 on which a film 5 with a pattern is formed is placed on a spin chuck 2 (FIG. 6 (A)), and the inventive composition for forming a wafer-edge-protection film 4 described above is applied onto the peripheral edge 1E of the substrate to be processed 1 from a supply nozzle 3 to obtain a coating film 4' (FIG. 6 (B)). Next, in the step (I-2), the coating film 4' is cured by a heat treatment or optical irradiation to form a wafer-edge-protection film 4A on the peripheral edge 1E of the substrate to be processed 1 (FIG. 6 (C)). Next, in the step (I-3), a pattern 1A is formed on the substrate to be processed 1 by dry etching while using the film 5 with a pattern as a mask (FIG. 6 (D)). Then, in the step (I-4), the film 5 with the pattern is removed (FIG. 6 (E)), followed by removal of the wafer-edge-protection film 4A (FIG. 6 (F)). Thereby, the pattern 1A is formed on the substrate to be processed 1.

When the wafer edge is damaged by dry etching, particles generated from the wafer edge may scatter toward the center of the wafer, it might cause pattern bridging or disconnection. In contrast, when the inventive patterning is used, the peripheral edge 1E (wafer edge; including the peripheral edge on the front surface side and the peripheral edge on the rear surface side) of the substrate to be processed 1 are protected by the wafer-edge-protection film 4A; therefore, it is possible to prevent occurrence of defects caused by the wafer edge 1E during the dry etching process, thereby enabling formation of patterns on the substrate to be processed 1 with high accuracy and less defects.

The film having a pattern and formed on the substrate to be processed is not particularly limited. Examples thereof include a resist upper layer film, a silicon-containing resist middle layer film, an inorganic hard mask middle layer film, and a resist underlayer film. Since the substrate to be processed is processed while using the film with a pattern as a mask, when the wafer-edge-protection film can be formed on the wafer edge using the composition for forming a wafer-edge-protection before dry etching is started, particle generation from the wafer edge can be prevented. Therefore, the film with a pattern is preferably a resist upper layer film.

The inventive patterning process is not limited to but is suitably used for multilayer resist processes, such as a silicon-containing two-layer resist process; a three-layer resist process using a resist underlayer film and a silicon-containing resist middle layer film; a four-layer resist process using a resist underlayer film, an inorganic hard mask middle layer film, and an organic thin film; and a silicon-free two-layer resist process. Therefore, a silicon-containing resist middle layer film, an inorganic hard mask middle layer film, an organic thin film, a resist underlayer film, and the like may be formed between the resist upper layer film in which a pattern is formed and the substrate to be processed, and a resist underlayer film or the like may be formed between the silicon-containing resist middle layer film or the inorganic hard mask middle layer film in which a pattern is formed and the substrate to be processed.

When the resist underlayer film is formed, the resist underlayer film can be formed by a method using a coating-type organic underlayer film composition, a CVD method, an ALD method, or the like. Examples of the coating-type organic underlayer film composition include resins and compositions disclosed in JP2012-1687A, JP2012-77295A, JP2004-264710A, JP2005-043471A, JP2005-250434A, JP2007-293294A, JP2008-65303A, JP2004-205685A, JP2007-171895A, JP2009-14816A, JP2007-199653A, JP2008-274250A, JP2010-122656A, JP2012-214720A, JP2014-29435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-44022A, and the like. Further, a resist underlayer film composition containing metal atoms such as Sn, In, Ga, Ge, Al, Ce, La, Cs, Zr, Hf, Ti, Bi, Sb, Zn, and the like may also be used.

When the inorganic hard mask middle layer film is formed, a silicon oxide film, a silicon nitride film, or a silicon oxynitride film (SiON film) are formed by a CVD method, an ALD method, or the like. The method for forming a nitride film is disclosed in JP2002-334869A and WO2004/066377A1. The thickness of the inorganic hard mask middle layer film is preferably 5 to 3,000 nm, more preferably 10 to 2,000 nm. Among them, for ArF exposure, SiON films having a high function as an antireflective film are most preferably used.

As the silicon-containing resist middle layer film, a polysilsesquioxane-based resist middle layer film is preferably used. The polysilsesquioxane-based resist middle layer film can be easily imparted an anti-reflective effect in excimer exposure, whereby the reflection light can be suppressed in pattern exposure of the resist upper layer film, and thus excellent resolution can be obtained. In particular, when a composition containing many aromatic groups is used as a resist underlayer film for 193-nm exposure, a k-value increases and thus substrate reflection also increases. However, the resist middle layer film can reduce the reflection, thereby enabling the substrate reflection to decrease to 0.5% or less. As the resist middle layer film having the anti-reflective effect, a polysilsesquioxane which has a pendant anthracene for exposure of 248 nm or 157 nm light, or a pendant phenyl group or a pendant light-absorbing group having a silicon-silicon bond for exposure of 193 nm light, and which is crosslinkable by acid or heat, is preferably used.

In the patterning process described above, the resist upper layer film may be of a positive type or a negative type, and any common photoresist composition may be used. Further, the photoresist composition may contain metal atoms such as Sn, In, Ga, Ge, Al, Ce, La, Cs, Zr, Hf, Ti, Bi, Sb, Zn, and the like. When a resist upper layer film is formed using the above photoresist composition, the formation can be performed by spin coating or by vapor deposition process using CVD or ALD.

When the photoresist composition is formed by spin coating, prebaking is conducted after application of the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

When a photoresist composition is formed by a vapor deposition process using CVD or ALD, the above resist composition is an EUV-sensitive metal oxide film, and the above metal is selected from Sn, Zr, Hf, Ti, Bi, Sb, and the like, preferably Sn, which has excellent EUV sensitivity. The metal oxide-containing film may be a photosensitive organometallic oxide film, such as an organotin oxide (e.g., haloalkyl Sn, alkoxyalkyl Sn, or amidoalkyl Sn), and the like. Some specific examples of suitable precursors include trimethyltin chloride, dimethyltin dichloride, methyltin trichloride, tris(dimethylamino)methyltin(IV), and (dimethylamino)trimethyltin(IV).

The metal oxide film may be deposited by PECVD or PEALD, for example, using a Lam Vector (registered trademark) tool. In the ALD example, the Sn oxide precursor is separated from O precursor/plasma. The deposition temperature is preferably in the range of 50°C to 600°C. The deposition pressure is preferably between 100 and 6000 mTorr. The flow rate of the precursor solution of the metal oxide-containing film (e.g., organotin oxide precursor) may be 0.01 to 10 cmm, and the gas flow rate (CO₂, CO, Ar, N₂) may be 100 to 10,000 sccm. The plasma power provided from high frequency plasma (e.g., 13.56 MHz, 27.1 MHz, or higher frequency) may be 200-1000 W per 300 mm wafer station. The deposition thickness is preferably 100 to 2000 Å.

Examples of light for exposure include high energy beams at wavelengths of 300 nm or less, specifically excimer lasers at 248 nm, 193 nm, or 157 nm, soft X-rays at 3 to 20 nm, an electron beam, and X-rays.

As a method for removing the wafer-edge-protection film from the wafer edge of the substrate to be processed after the patterning process on the substrate to be processed, removal by dry etching is preferable. When the wafer-edge-protection film is removed by the dry etching, the wafer-edge-protection film can be removed by etching using oxygen-based or hydrogen-based wafer-edge-protection gases because the wafer-edge-protection film is constituted of an organic film.

For example, when the substrate contains Si, SiO₂, SiN, SiON, or silica-based low dielectric constant insulating film, which is resistant to etching using oxygen-based or hydrogen-based gas, the wafer-edge-protection film can be removed without damaging the wafer edge of the substrate to be processed.

When the wafer edge is damaged by dry etching, particles generated from the wafer edge may scatter toward the center of the wafer, thereby causing pattern bridging or disconnection. In contrast, in case of the inventive patterning process, the peripheral edge (e.g. including the edge surface on a front surface side and the edge surface on a rear surface side) are protected by a wafer-edge-protection film, and therefore, it is possible to prevent occurrence of defects caused by the wafer edge during the dry etching process, thereby enabling formation of a pattern on the substrate to be processed with high accuracy and fewer defects. It is also possible to reduce a risk of adherence of particles generated by etching of a film containing metal atoms to the wafer edge, which causes metal contamination of the wafer edge.

In addition, as the patterning process according to the second embodiment, the present invention provides a patterning process in which a wafer-edge-protection film is formed on a peripheral edge of a substrate to be processed and a pattern is formed on the substrate to be processed, comprising the steps of:
(II-1) applying the inventive composition for forming a wafer-edge-protection film onto a peripheral edge of a substrate to be processed to obtain a coating film;
(II-2) curing the coating film by heat treatment or optical irradiation to form a wafer-edge-protection film on the peripheral edge of the substrate to be processed;
(II-3) forming a resist upper layer film pattern on the substrate to be processed, and forming a pattern on the substrate to be processed by dry etching while using the resist upper layer film pattern as a mask; and
(II-4) removing the wafer-edge-protection film.

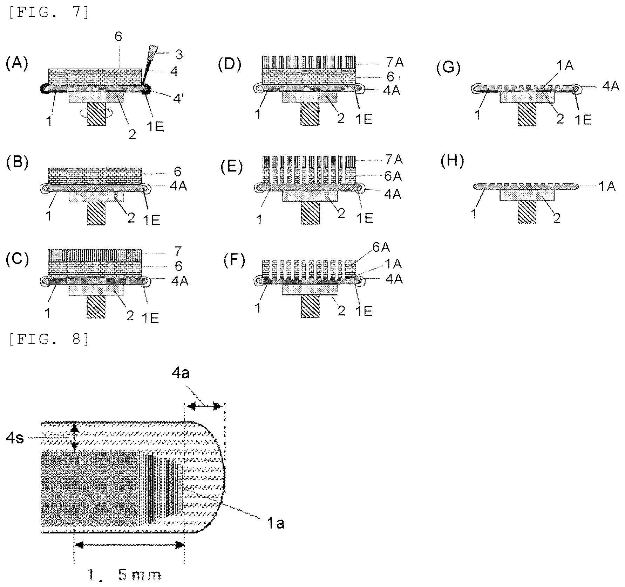

An example of the inventive patterning process according to the second embodiment is specifically explained below using FIG. 7. First, in the step (II-1), the inventive composition 4 for forming a wafer-edge-protection film described above is applied onto the peripheral edge 1E of the substrate to be processed 1 placed on a spin chuck 2 from a supply nozzle 3 to obtain a coating film 4' (FIG. 7 (A)). The substrate to be processed may have a layer to be processed 6 formed thereon, such as a silicon-containing resist middle layer film, an inorganic hard mask middle layer film, an organic thin film, or a resist underlayer film (FIG. 7 (A)). Next, in the step (II-2), the coating film 4' of the composition for forming a wafer-edge-protection film 4 is cured by a heat treatment or optical irradiation to form a wafer-edge-protection film 4A on the peripheral edge 1E (FIG. 7 (B)). Next, in the step (II-3), a resist upper layer film 7 is formed on the layer to be processed 6 (FIG. 7 (C)), followed by exposure to light or the like, thereby forming a resist upper layer film pattern 7A (FIG. 7 (D)). A pattern 6A is formed on the layer to be processed 6 by dry etching while using the resist upper layer film pattern 7A as a mask (FIG. 7 (E)), and further, a pattern 1A is formed on the substrate to be processed 1 by dry etching while using the pattern 6A as a mask (FIG. 7 (F)). Then, in the step (II-4), the layer to be processed 6 with the pattern 6A is removed (FIG. 7 (G)), followed by removal of the wafer-edge-protection film 4A (FIG. 7 (H)).

With the above patterning process, it is possible to suppress particle generation from the wafer edge when the substrate to be processed is dry-etched. Further, it is possible to avoid the risk that the chemical solution supplied onto the front surface of the substrate runs to the peripheral edge on the rear surface, resulting in forming a coating film also on these unintended peripheral edge on a rear surface during the formation of the resist upper layer film, which would result in contamination of these areas.

When a resist upper layer film is formed using the above photoresist composition, the formation is preferably performed by spin coating. When the photoresist composition is formed by spin coating, prebaking is conducted after the application of the resist. The prebaking is preferably performed at 60 to 180°C for 10 to 300 seconds. Thereafter, exposure is conducted according to a usual manner, followed by post-exposure baking (PEB) and development, thereby obtaining a resist upper layer film pattern. Although the thickness of the resist upper layer film is not particularly limited, the thickness is preferably 10 to 500 nm for example, particularly preferably 20 to 400 nm.

In the patterning process described above, the resist upper layer film may be of a positive type or a negative type, and any common photoresist composition and metal atom-containing photoresist composition may be used.

When the above resist upper layer film used in the above patterning process is a composition containing a metal atom, the above patterning process using the inventive composition for forming a wafer-edge-protection film is particularly effective in terms of inhibiting contamination of the wafer edges on the front surface side and the rear surface side. Therefore, the above resist upper layer film is preferably formed from a composition containing a metal atom.

When the above photoresist composition contains a metal atom, the metal atom is preferably Sn, In, Ga, Ge, Al, Ce, La, Cs, Zr, Hf, Ti, Bi, Sb or Zn, and particularly preferably Sn, Zr, Hf and Ti.

Examples of light for exposure include high energy beams at wavelengths of 300 nm or less, specifically excimer laser beams at 248 nm, 193 nm, and 157 nm, soft X-rays at 3 to 20 nm, an electron beam, and X-rays. Among these, extreme ultraviolet having a wavelength of 3 to 15 nm is preferable.

In the above patterning process, a silicon-containing resist middle layer film, an inorganic hard mask middle layer film, an organic thin film, a resist underlayer film, and the like may be formed between the substrate to be processed and the resist upper layer film.

The above patterning process may contain: applying the inventive composition for forming a wafer-edge-protection film onto a peripheral edge of a substrate to be processed, a substrate in which a resist underlayer film is formed on a substrate to be processed, a substrate in which a resist underlayer film and a silicon-containing resist middle layer film or an inorganic hard mask are formed on a substrate to be processed, a substrate in which a resist underlayer film, an inorganic hard mask and an organic thin film are formed on a substrate to be processed, or a substrate in which a silicon-containing resist middle layer film or an inorganic hard mask is formed on a substrate to be processed to form a coating film; curing the coating film to form a wafer-edge-protection film; and then applying a resist upper layer film.

The inventive patterning process is suitably used for multilayer resist processes, such as a silicon-containing two-layer resist process, a three-layer resist process using a resist underlayer film and a silicon-containing resist middle layer film, a four-layer resist process using a resist underlayer film, an inorganic hard mask middle layer film, and an organic thin film, and a silicon-free two-layer resist process.

As the method for removing the inventive wafer-edge-protection film from the wafer edge of the substrate to be processed after completion of patterning on the substrate to be processed, removal by dry etching is preferable. When the wafer-edge-protection film is removed by dry etching, the wafer-edge-protection film can be removed by etching using oxygen-based or hydrogen-based gases because the wafer-edge-protection film is constituted of an organic film.

For example, when the substrate is Si, SiO₂, SiN, SiON, or silica-based low dielectric constant insulating film, which is resistant to etching using oxygen-based or hydrogen-based gas, the wafer-edge-protection film can be removed without damaging the wafer edge of the substrate to be processed.

When the wafer edge is damaged by dry etching, particles generated from the wafer edge may scatter toward the center of the wafer, thereby causing pattern bridging or disconnection. In contrast, in case of the inventive patterning process, the peripheral edge (e.g. including the edge surface on a front surface side and the edge surface on a rear surface side) of the substrate to be processed are protected by the wafer-edge-protection film with excellent dry etching resistance, and therefore, it is possible to prevent occurrence of defects caused by the wafer edge during the dry etching process, thereby enabling formation of a pattern on the substrate to be processed with high accuracy and fewer defects. In addition, when the resist upper layer film used for the above patterning process is a composition including a metal atom, the above patterning process using the inventive composition for forming a wafer-edge-protection film functions effectively especially from the viewpoint of preventing contamination of the wafer edges on the front surface side and on the rear surface side.

### EXAMPLES

Hereinbelow, the present invention is specifically explained by showing Examples and Comparative Examples, but the present invention is not limited by these descriptions. It should be noted that the molecular weight and the dispersity were measured by the following method. The weight-average molecular weight (Mw) in terms of polystyrene was measured by gel permeation chromatography (GPC) using tetrahydrofuran as an eluent, and the dispersity (Mw/Mn) was calculated.

### [Synthesis Examples]

In the following synthesis examples, any of the following phenols (a-1) to (a-2) and any of the following difluoro compounds (halogenated aryl compounds) (b-1) to (b-3) were used. For the comparative compounds (R-1) to (R-2), the following comparative-example synthesis raw materials (r-1) to (r-3) were used.

The used phenols (a-1) to (a-2) are shown below.

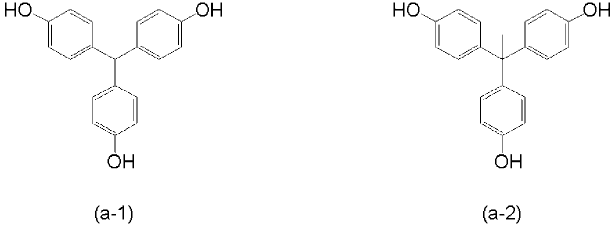

The used difluoro compounds (b-1) to (b-3) are shown below.

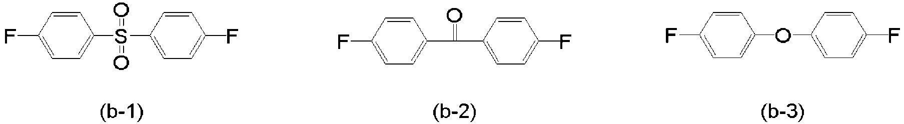

The used comparative-example synthesis raw materials (r-1) to (r-3) are shown below.

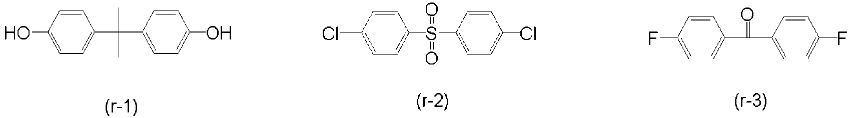

### [Synthesis Example 1] Synthesis of polymer (A-1)

80 g of N-methylpyrrolidone was added to 8.8 g of phenols (a-1), 11.4 g of difluoro compound (b-1), and 12.4 g of potassium carbonate, and the reaction was conducted in a nitrogen atmosphere at an internal temperature of 150°C for 15 hours. After cooling the reaction solution at room temperature, 50 ml of methylisobutylketone, 50 ml of tetrahydrofuran, and 100 ml of pure water were added to the reaction solution for homogenization, and the separated water layer was removed. Further, the organic layer was washed with 100 ml of a 3% aqueous solution of nitric acid twice and washed with 100 ml of pure water five times, and then the organic layer was evaporated under reduced pressure to dryness. 30 g of THF was added to the residue to yield a homogeneous solution, and a crystal was precipitated by 150 g of methanol. The precipitated crystal was separated by filtration, washed twice with 30 g of methanol, and recovered. The recovered crystal was vacuum-dried at 70°C, thereby obtaining a polymer (A-1).

The weight-average molecular weight (Mw) and the dispersity (Mw/Mn) were determined by GPC, and the following results were obtained. (A-1): Mw=22230, Mw/Mn=6.91

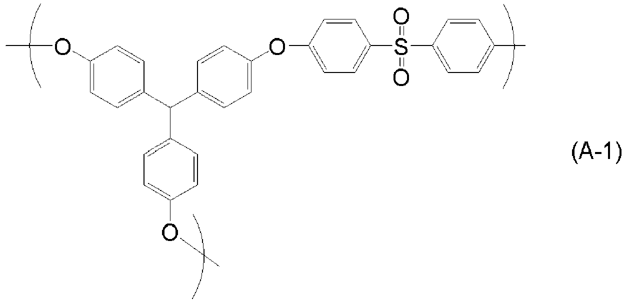

### [Synthesis Example 2] Synthesis of polymer (A-2)

80 g of N-methylpyrrolidone was added to 8.8 g of phenols (a-1), 9.8 g of difluoro compound (b-2), and 12.4 g of potassium carbonate, and the reaction was conducted in a nitrogen atmosphere at an internal temperature of 150°C for 15 hours. After cooling the reaction solution at room temperature, 50 ml of methylisobutylketone, 50 ml of tetrahydrofuran, and 100 ml of pure water were added to the reaction solution for homogenization, and the separated water layer was removed. Further, the organic layer was washed with 100 ml of a 3% aqueous solution of nitric acid twice and washed with 100 ml of pure water five times, and then the organic layer was evaporated under reduced pressure to dryness. 30 g of THF was added to the residue to yield a homogeneous solution, and a crystal was precipitated by 150 g of methanol. The precipitated crystal was separated by filtration, washed twice with 30 g of methanol, and recovered. The recovered crystal was vacuum-dried at 70°C, thereby obtaining a polymer (A-2).

The weight-average molecular weight (Mw) and the dispersity (Mw/Mn) were determined by GPC, and the following results were obtained. (A-2): Mw=18990, Mw/Mn=5.83

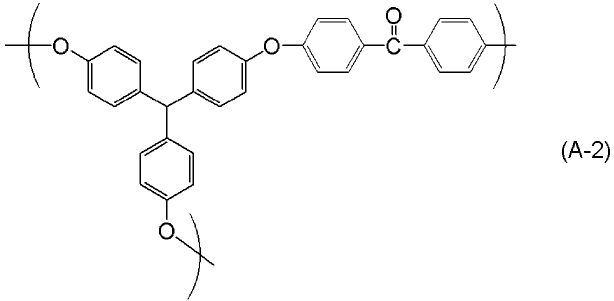

### [Synthesis Example 3] Synthesis of polymer (A-3)

80 g of N-methylpyrrolidone was added to 9.2 g of phenols (a-2), 9.3 g of difluoro compound (b-3), and 12.4 g of potassium carbonate, and the reaction was conducted in a nitrogen atmosphere at an internal temperature of 150°C for 15 hours. After cooling the reaction solution at room temperature, 50 ml of methylisobutylketone, 50 ml of tetrahydrofuran, and 100 ml of pure water were added to the reaction solution for homogenization, and the separated water layer was removed. Further, the organic layer was washed with 100 ml of a 3% aqueous solution of nitric acid twice and washed with 100 ml of pure water five times, and then the organic layer was evaporated under reduced pressure to dryness. 30 g of THF was added to the residue to yield a homogeneous solution, and a crystal was precipitated by 150 g of methanol. The precipitated crystal was separated by filtration, washed twice with 30 g of methanol, and recovered. The recovered crystal was vacuum-dried at 70°C, thereby obtaining a polymer (A-3).

The weight-average molecular weight (Mw) and the dispersity (Mw/Mn) were determined by GPC, and the following results were obtained. (A-3): Mw=9980, Mw/Mn=3.39

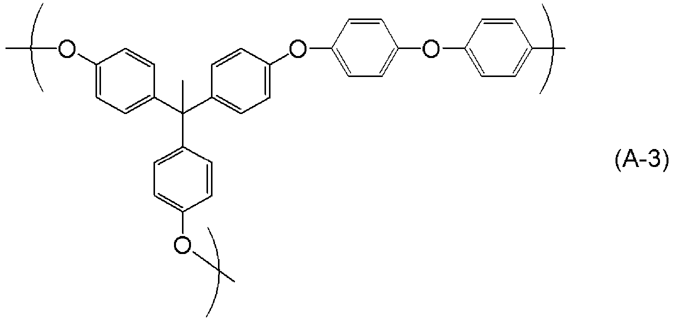

### [Comparative Synthesis Example 1] Synthesis of Comparative Example Polymer (R-1)

45.6 g of comparative-example synthesis raw material (r-1), 57.4 g of comparative-example synthesis raw material (r-2), 55.3 g of dry potassium carbonate, 400 mL of DMA (dimethylacetamide), and 50 mL of toluene were charged to a 2 L, four-neck, round-bottom flask equipped with a condenser, a nitrogen sweep, a Dean-Stark trap (filled with toluene), and an overhead mechanical stirrer. The mixture was mixed at room temperature for 10 minutes. The reaction mixture was heated on a heating mantle at 150°C for 9.5 hours. The reaction mixture was then cooled to below 50°C and filtered through filter paper. The filtered solution (pH 9-10) was neutralized to pH 7-6 with 10% HCl and then poured into deionized water (3200 mL) in a 5 L flask. Precipitates formed. The mixture was mixed for 30 minutes and allowed to settle overnight. The water was decanted (3400 mL), and 1 liter of THF was added to the sticky solid. After mixing, the mixture was transferred to a beaker and heated on a hot plate to reduce the volume to 1 liter. The solution was poured into 12 liters of hexane, mixed for 1 hour, and then the solids were allowed to settle to precipitate the polymer. The solution was filtered through filter paper and washed with hexane. The polymer was dried in a vacuum furnace at 80°C for two days to obtain 85 g of Comparative Example Polymer (R-1).

The weight-average molecular weight (Mw) and the dispersity (Mw/Mn) were determined by GPC, and the following results were obtained. (R-1): Mw=9769, Mw/Mn=2.23

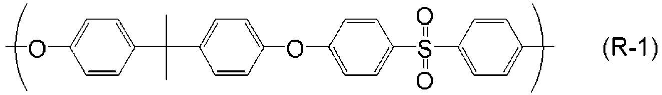

### [Comparative Synthesis Example 2] Synthesis of Comparison Example Polymer (R-2)

22.8 g of comparative-example synthesis raw material (r-1), 21.8 g of comparative-example synthesis raw material (r-3), 27.6 g of potassium carbonate, 200 mL of dimethylacetamide, and 27.5 mL of toluene were charged to a 500 mL, four-neck, round-bottom flask equipped with a stirrer, a condenser, a thermowatch, a Dean-Stark trap filled with toluene, and a nitrogen purge. The mixture was mixed at room temperature for 10 minutes, and the temperature was set at 150°C. Since reflux began at 147°C, the solution was maintained under reflux for 90 minutes. The solution was then cooled to below 70°C and salts were removed by filtration, and the filtered solution was neutralized with a small quantity of 10% HCl. Then, the solution was poured into 1600 mL of deionized water for precipitation and mixed for 1 hour, and the solids were allowed to settle. The water layer was poured out, and 500 mL of tetrahydrofuran was added thereto. The solution was mixed for 30 minutes, transferred to a beaker, and reduced to have the volume of 600 mL. The solution was poured into 3 liters of hexane, allowed to precipitate the polymer, filtered, washed, dried, and allowed to stand in a vacuum furnace for one night, to obtain 37 g of Comparative Polymer (R-2).

The weight-average molecular weight (Mw) and the dispersity (Mw/Mn) were determined by GPC, and the following results were obtained. (R-2): Mw=15125, Mw/Mn=2.10

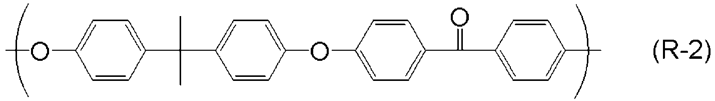

### [(C) Crosslinking Agent]

Each of the crosslinking agents (C) used for the composition for forming a wafer-edge-protection film is shown below.

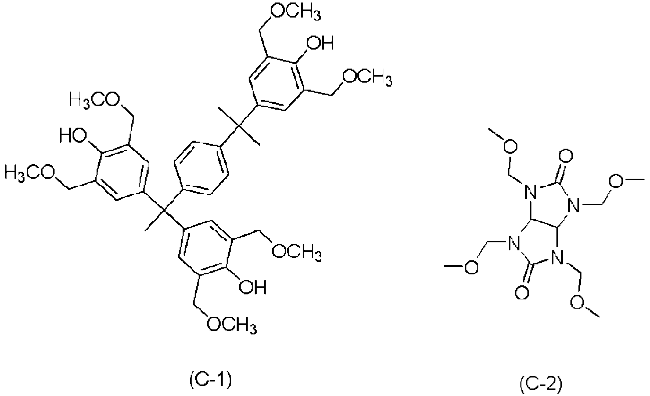

### [High-Boiling-point Solvent]

The high-boiling-point solvent (diethylene glycol monobenzyl ether: boiling point 302°C) used for the composition for forming a wafer-edge-protection film is shown below.

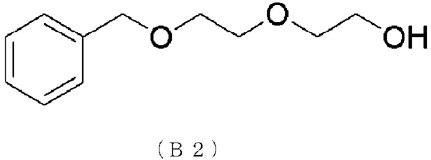

### [(E) Thermal Acid Generator]

The thermal acid generator (F) used for the composition for forming a wafer-edge-protection film is shown below.

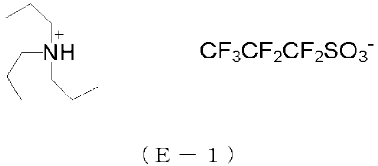

### [Preparation of Compositions for Forming Wafer-Edge-Protection film EPF-1]

As the polymer (A), the polymer (A-1) was dissolved at the proportion shown in Table 1 in cyclohexanone (CyHO) as the main solvent containing 0.5 mass% of a surfactant FC-4430 (manufactured by Sumitomo 3M Limited), and the solution was filtered through a 0.02 µm membrane filter to prepare a composition for forming a wafer-edge-protection film (EPF-1).

### [Preparation of Compositions for Forming Wafer-Edge-Protection film EPF-2 to EPF-6 and Comparative EPF-1 to EPF-3]

Each composition was prepared in the same manner as that for the composition for forming a wafer-edge-protection film EPF-1, except that the type and the content of each component were set as shown in Table 1. It should be noted that in Table 1, "-" indicates that the component was not used.

**[Table 1]**

| Composition for forming wafer-edge-protection film | (A) Polymer (A) (parts by mass) | (C) Crosslinking Agent (parts by mass) | (E) Acid Generator (parts by mass) | (B) Solvent | |
|---|---|---|---|---|---|
| | | | | High-Boiling-Point Solvent (parts by mass) | Main Solvent (parts by mass) (including 0.5 mass% of surfactant) |
| EPF-1 | A-1 (100) | - | - | - | CyHO (300) |
| EPF-2 | A-2 (100) | - | - | - | CyHO (300) |
| EPF-3 | A-3 (100) | - | - | - | CyHO (300) |
| EPF-4 | A-1 (100) | C-1 (50) | - | - | CyHO (300) |
| EPF-5 | A-2 (100) | C-2 (50) | E-1 (2) | - | CyHO (300) |
| EPF-6 | A-3 (100) | - | - | B2 (50) | CyHO (300) |
| Comparative EPF-1 | R-1 (100) | - | - | - | GBL (300) |
| Comparative EPF-2 | R-2 (100) | - | - | - | GBL (300) |
| Comparative EPF-3 | R-1 (100) | C-2 (50) | E-1 (2) | - | GBL (300) |

### [Examples 1-1 to 1-6 and Comparative Examples 1-1 to 1-3: Evaluation of Thickness of Wafer-Edge-Protection film]

Each of the above composition for forming a wafer-edge-protection film (EPF-1 to 6 and Comparative EPF-1 to 3) was supplied by spin coating onto a peripheral edge (wafer edge) of a silicon wafer to form a coating film on the wafer edge. Then, the coating film formed on the peripheral edge was cured by baking the coating film for 60 seconds at the temperature shown in Table 2. Thus, wafer-edge-protection films each were formed.

The thickness of each of the wafer-edge-protection film formed on the wafer edge was evaluated by observation of cross section using an electron microscope (S-4700) manufactured by Hitachi, Ltd. As shown in FIG. 8, thickness of a portion (at 1.5 mm distance from the apex 1a toward the center of the wafer) where a wafer edge surface is coated was defined as 4S and thickness of a portion where apex 1a is coated was defined as 4a as evaluation potions, and the observation was performed.

**[Table 2]**

| | Composition for forming wafer-edge-protection film | Temperature in baking (°C) | Film Thickness | |
|---|---|---|---|---|
| | | | At Covered Portion on Edge Surface (nm) | At Covered Portion on Apex (nm) |
| Example 1-1 | EPF-1 | 350 | 345 | 1768 |
| Example 1-2 | EPF-2 | 350 | 357 | 1554 |
| Example 1-3 | EPF-3 | 350 | 364 | 1615 |
| Example 1-4 | EPF-4 | 350 | 361 | 1693 |
| Example 1-5 | EPF-5 | 350 | 317 | 1772 |
| Example 1-6 | EPF-6 | 350 | 326 | 1723 |
| Comparative Example 1-1 | Comparative EPF-1 | 350 | 359 | 1818 |
| Comparative Example 1-2 | Comparative EPF-2 | 350 | 315 | 1470 |
| Comparative Example 1-3 | Comparative EPF-3 | 350 | 375 | 1754 |

As shown in Table 2, the wafer-edge-protection film forming method using the inventive composition for forming a wafer-edge-protection film (EPF-1 to EPF-6) enables desirable coating of surfaces from the wafer edge area to the apex area.

### [Examples 2-1 to 2-6 and Comparative Examples 2-1 to 2-3: Evaluation of Etching Resistance]

Each of the composition for forming a wafer-edge-protection film (EPF-1 to 6 and Comparative Examples EPF-1 to 3) prepared above was applied onto the surface of a silicon substrate to obtain a coating film, and each of the coating films was baked in the atmosphere at the temperature shown in FIG. 3 for 60 seconds to form a 1200 nm protection film. Thickness of the formed protection films were measured as film thickness "A". Next, etching using CF₄ gas and O₂ gas was performed for 1 minute under the following conditions using an etching apparatus Telius manufactured by Tokyo Electron Ltd., and the thickness of the protection film after the etching was measured as the thickness "B". The film thickness etched (film thickness "B" - film thickness "A") per minute was calculated as etching resistance.

For the etching using CF₄ gas, the case where the difference between the film thickness "B" and "A" was less than 75 nm was evaluated as "A" (significantly desirable), the case where the film thickness difference was 75 nm or more and less than 80 nm was evaluated as "B" (desirable), and the case the film thickness difference was 80 nm or more was evaluated as "C" (poor). For the etching using O₂ gas, the case where the film thickness difference between "B" and "A" was less than 110 nm was evaluated as "A" (significantly desirable), the case where the film thickness difference was 110 nm or more and less than 120 nm was evaluated as "B" (desirable), and the case where the thickness difference was 120 nm or more was evaluated as "C" (poor). Table 3 shows the results.

### Conditions of Dry Etching using CF₄ Gas

Chamber pressure: 100 mT
RF-power (upper portion): 500W
RF-power (lower portion): 400W
CF₄ gas flow rate: 300 sccm
Time: 60 sec

### Conditions of Dry Etching using O₂ Gas

Chamber pressure: 15 mT
RF-power (upper portion): 300W
RF-power (lower portion): 50W
O₂ gas flow rate: 30 sccm
N₂ gas flow rate: 270 sccm
Time: 60 sec

**[Table 3]**

| | Composition for forming wafer-edge-protection film | Temperature in baking (°C) | Etching Resistance | |
|---|---|---|---|---|
| | | | CF₄ | O₂ |
| Example 2-1 | EPF-1 | 350 | A | A |
| Example 2-2 | EPF-2 | 350 | A | A |
| Example 2-3 | EPF-3 | 350 | A | A |
| Example 2-4 | EPF-4 | 350 | B | B |
| Example 2-5 | EPF-5 | 350 | B | B |
| Example 2-6 | EPF-6 | 350 | A | A |
| Comparative Example 2-1 | Comparative EPF-1 | 350 | C | C |
| Comparative Example 2-2 | Comparative EPF-2 | 350 | C | C |
| Comparative Example 2-3 | Comparative EPF-3 | 350 | C | C |

As shown in Table 3, it has been found that the inventive composition for forming a wafer-edge-protection films (EPF-1 to EPF-6) have excellent dry etching resistance with respect to CF₄ gas and O₂ gas. The polymer (A) represented by the general formula (1) has a repeating unit having a trifunctional structure of the polymer, which gives the film high density, and is therefore thought to have enhanced dry etching resistance.

On the other hand, the compositions for forming a wafer-edge-protection film (Comparative Examples EPF-3 to 5) without a trifunctional structure represented by the general formula (1) exhibited insufficient dry etching resistance. In comparison between EPF-1 and Comparative EPF-1 having the same diphenyl sulfone structure, or in comparison between EPF-2 and Comparative Example EPF-2 having the same benzophenone structure, EPF-1 and EPF-2 having the trifunctional structure represented by the general formula (1) is superior in dry etching resistance. Therefore, it is assumed that the trifunctional structure represented by the general formula (1) contributes to the formation of a dense cured film.

As described above, it has been found that the compositions for forming a wafer-edge-protection film (EPF-1 to EPF-6) to be used in the inventive wafer-edge-protection film forming method have excellent dry etching resistance with respect to CF₄ gas and O₂ gas. Therefore, the wafer-edge-protection film forming method using these compositions can be expected to function as a wafer-edge-protection film that can protect the wafer edge from etchants until etching of the substrate to be processed is complete, even in dry etching processes that form a fine pattern with a high aspect ratio, which is represented by that for a 3D-NAND memory that have been increasingly highly laminated

### [Examples 3-1 to 3-6 and Comparative Examples 3-1 to 3-3: Quantity of Metal Impurities on Peripheral Edge Surface of Wafer]

The quantity of metal impurities on the wafer peripheral edge generated from the metal-containing resist upper layer film was evaluated. The metal-containing compounds (M-1) to (M-3) used for this evaluation were synthesized as follows.

### [Synthesis of Metal-Containing Compound (M-1)]

340 g of titanium tetrabutoxide was dissolved in 500 g of 1-butanol, and a mixed solution of 27 g of deionized water and 500 g of 1-butanol was added thereto dropwise over 2 hours at room temperature while stirring. 1,200 g of propylene glycol monomethylether acetate (PGMEA) was added to the resulting solution, and the mixture was heated at 50°C under reduced pressure until distillation of 1-butanol stopped, thereby obtaining 1,000 g of a solution of titanium-containing compound (metal-containing compound (M-1)) in PGMEA. The molecular weight in terms of polystyrene of this compound was measured, with the result of Mw=1,050.

### [Synthesis of Metal-Containing Compound (M-2)]

480 g of an 80 mass% solution of zirconium tetraisopropoxide in 1-butanol was dissolved in 400 g of 1-butanol, and a mixed solution of 27 g of deionized water and 500 g of 1-butanol was added dropwise thereto over 2 hours at room temperature while stirring. 90 g of 1,3-butanediol was added to the resulting solution, followed by stirring at room temperature for 30 minutes. This solution was concentrated at 30°C under reduced pressure, and further heated to 60°C. The heating was continued under reduced pressure until no distillates were produced. At a point where distillates were no longer observed, 1,200 g of PGMEA was added, and the mixture was heated at 40°C under reduced pressure until distillation of 1-butanol stopped, thereby obtaining 1,000 g of a solution of a zirconium-containing compound (metal-containing compound (M-2)) in PGMEA. The molecular weight in terms of polystyrene of this compound was measured, with the result of Mw=1,400. 1,400.

### [Synthesis of Metal-Containing Compound (M-3)]

480 g of an 80 mass% solution of hafnium tetraisopropoxide in 1-butanol was dissolved in 400 g of 1-butanol, and a mixed solution of 27 g of deionized water and 500 g of 1-butanol was added dropwise thereto over 2 hours at room temperature while stirring. 90 g of 1,3-butanediol was added to the resulting solution, followed by stirring at room temperature for 30 minutes. This solution was concentrated at 30°C under reduced pressure, and further heated to 60°C. The heating was continued under reduced pressure until no distillates were produced. At a point where distillates were no longer observed, 1,200 g of PGMEA was added, and the mixture was heated at 40°C under reduced pressure until distillation of 1-butanol stopped, thereby obtaining 1,000 g of a solution of a hafnium-containing compound (metal-containing compound (M-3)) in PGMEA. The molecular weight in terms of polystyrene of this compound was measured, with the result of Mw=1,500.

### [Preparation of Composition for Forming Metal-Containing Resist Upper Layer Film]

Each of the metal-containing compounds (M-1) to (M-3) obtained in the above Synthesis Examples was dissolved in a solvent, in which a fluorine-based surfactant FC-4430 manufactured by 3M Company was dissolved in 100 ppm as a surfactant, according to the formulations shown in Table 4. Each solution thus obtained was filtered through a 0.2 µm filter to prepare composition for forming a metal-containing resist upper layer film MR-1 to MR-3.

The formulations in the following Table 4 are as follows.

Acid generator: PAG-1, 2 (see the following structural formula)

Basic compound: Base-1 (see the following structural formula)

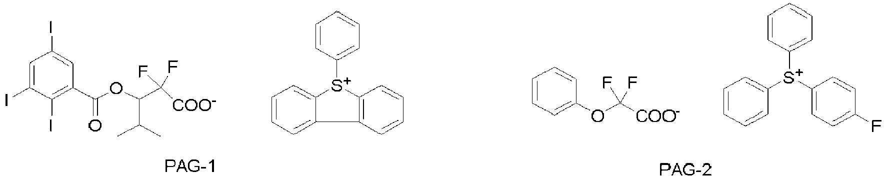

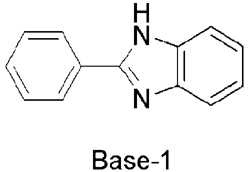

**[Table 4]**

| Composition for forming metal-containing resist upper layer film | Metal-containing Compound (parts by mass) | Acid Generator (parts by mass) | Base Compound (parts by mass) | Solvent (parts by mass) |
|---|---|---|---|---|
| MR-1 | M-1 (100) | PAG-1 (10) | Base-1 (2) | PGMEA (6000) |
| MR-2 | M-2 (100) | PAG-2 (5) | Base-1 (2) | PGMEA (6000) |
| MR-3 | M-3 (100) | PAG-2 (5) | Base-1 (2) | PGMEA (6000) |

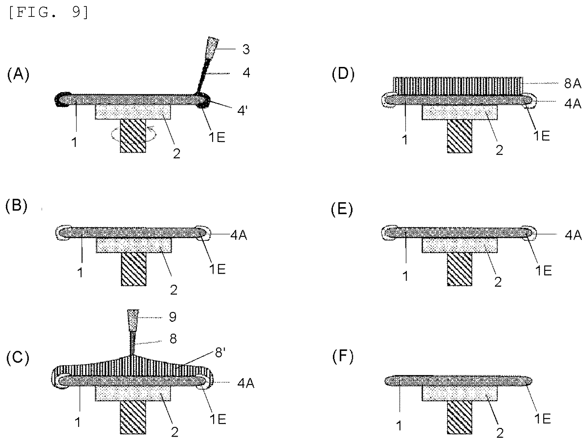

As shown in FIG. 9, the composition 4 for forming a wafer-edge-protection film (EPF-1 to EPF-6 and Comparative EPF-1 to EPF-3) prepared above was applied from the supply nozzle 3 to the peripheral edge (peripheral edge 1E) on the front surface side and on the rear surface side of the silicon substrate 1 to obtain a coating film 4' (FIG. 9 (A)). Next, the coating film 4' was cured by baking at 350°C for 60 seconds in the atmosphere to form a wafer-edge-protection film 4A (FIG. 9 (B)). Then, each of the composition 8 for forming a metal-containing resist upper layer film (MR-1 to MR-3 described above) was applied from a resist supply nozzle 9 to the surface portion of the silicon substrate to obtain a coating film 8' (FIG. 9 (C)). Next, the coating film 8' was pre-baked on a hotplate at 170°C for 60 seconds to form a metal-containing resist upper layer film 8A of 35 nm (FIG. 9 (D)). Subsequently, the above metal-containing resist upper layer film 8A was removed using a developer (butyl acetate) (FIG. 9 (E)), and then the wafer-edge-protection film 4A formed on the peripheral edge (peripheral edge 1E) on the front surface side and on the rear surface side of the silicon substrate 1 was removed by dry etching using O₂ gas (FIG. 9 (F)). The peripheral edge (peripheral edge 1E) on the front surface side and on the rear surface side of the silicon substrate 1 was treated with a mixed liquid of hydrofluoric acid and hydrogen peroxide water, and the solution was recovered and evaluated using Expert VPD-ICP-MS manufactured by IAS Inc. The case where the quantity of metal atom impurities is 1.0×10E⁺¹⁰ (atoms/cm²) or less was evaluated as "A" (desirable), and the case where the quantity of metal atom impurities is more than 1.0×10E⁺¹⁰ (atoms/cm²) was evaluated as "B" (poor). Table 5 shows the results.

In addition, the number of defects in the wafer edge portion after the above-described etching was evaluated using VisEdge manufactured by KLA-Tencor Corporation. The case where the number of defects present in the wafer edge portion 1E was less than 30 was evaluated as "A" (very good), the case where it was 30 or more and less than 100 was evaluated as "B" (good), and the case where it was 100 or more was rated "C" (poor). The results are shown in Table 5.

**[Table 5]**

| | Composition for forming wafer-edge-protection film | composition for forming a metal-containing resist upper layer film | | | Number of defects (/wf) |
|---|---|---|---|---|---|
| | | MR-1 (Ti) | MR-2 (Zr) | MR-3 (Hf) | |
| Example 3-1 | EPF-1 | A | A | A | A |
| Example 3-2 | EPF-2 | A | A | A | A |
| Example 3-3 | EPF-3 | A | A | A | A |
| Example 3-4 | EPF-4 | A | A | A | B |
| Example 3-5 | EPF-5 | A | A | A | B |
| Example 3-6 | EPF-6 | A | A | A | A |
| Comparative Example 3-1 | Comparative EPF-1 | B | B | B | C |
| Comparative Example 3-2 | Comparative EPF-2 | B | B | B | C |
| Comparative Example 3-3 | Comparative EPF-3 | B | B | B | C |

As shown in Table 5, by forming a wafer-edge-protection film on the peripheral edge including the peripheral edge on the front surface side and the peripheral edge on the rear surface side of the substrate by using the inventive composition for forming a wafer-edge-protection film (EPF-1), sufficient etching resistance was obtained, and therefore, the amount of metal adhering when applying a composition for forming a metal-containing resist upper layer film was applied onto the silicon substrate significantly decreased compared with the case in which the Comparative EPF-1 to EPF-3 was used, resulting in favorable performance.

As described above, by using the inventive compositions for forming a wafer-edge-protection film (EPF-1 to EPF-6), the quantity of metal adhering to a silicon substrate when applying the composition thereon can be reduced, making it possible to form a wafer-edge-protection film that is excellent also in defect reduction characteristics.

As explained above, the wafer-edge-protection film forming method using the inventive composition for forming a wafer-edge-protection film can provide a wafer-edge-protection film that is superior in dry etching resistance to the conventional wafer-edge-protection films and has excellent film-formability even on a wafer edge portion that is difficult to be coated. Further, by forming a wafer-edge-protection film also on a peripheral edge on a rear surface side, it is possible to avoid the risk that the chemical solution supplied onto the front surface of the substrate runs to the peripheral edge on the rear surface, resulting in forming a coating film also on these unintended peripheral edge on a rear surface during formation of a coating film containing metal, which would result in contamination of these areas. Therefore, the inventive composition for forming a wafer-edge-protection film can be suitably used for formation of a fine resist pattern in the lithography steps for various electronic devices, such as semiconductor devices, liquid crystal devices, and the like, which are expected to undergo further miniaturization in the future.

The present description includes the following embodiments.
[1]: A composition for forming a wafer-edge-protection film for forming a wafer-edge-protection film on a peripheral edge of a substrate, comprising:
   a polymer (A) represented by the following general formula (1); and
   a solvent, 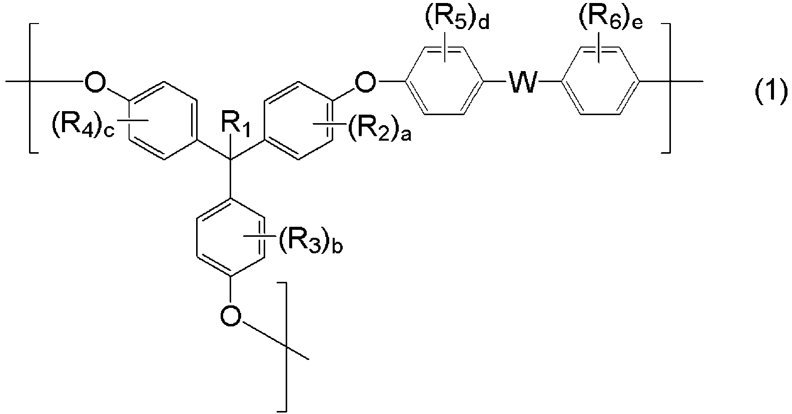
   wherein "W" represents -SO₂-, -C(=O) -, or -O-; R₁, R₂, R₃, R₄, and R₅ each independently represent a halogen atom, a monovalent organic group having 1 to 3 carbon atoms, or a hydroxy group; and "a", "b", "c", "d", and "e" each independently represent an integer of 0 to 4.
[2] : The composition for forming a wafer-edge-protection film of [1], wherein the polymer (A) has a weight-average molecular weight of 1,000 to 30,000.
[3]: The composition for forming a wafer-edge-protection film of [1] or [2], wherein the polymer (A) is contained in 10 mass% or more.
[4]: The composition for forming a wafer-edge-protection film of any one of [1] to [3], further comprising one or more kinds of: a crosslinking agent; a surfactant; an acid generator; and a plasticizer.
[5]: The composition for forming a wafer-edge-protection film of any one of [1] to [4], wherein the solvent is a mixture of a high-boiling-point solvent having a boiling point of 180°C or more and a low-boiling-point solvent having a boiling point of less than 180°C.
[6] : A wafer-edge-protection film forming method for forming a wafer-edge-protection film on a peripheral edge of a substrate, comprising the steps of:
   (i) coating a peripheral edge of the substrate with the composition for forming a wafer-edge-protection film of any one of [1] to [5] to obtain a coating film; and
   (ii) curing the coating film by heat or optical irradiation to form the wafer-edge-protection film on the peripheral edge of the substrate.
[7]: The wafer-edge-protection film forming method of [6], wherein, in the step (i), in addition to an edge surface on a front surface side of the peripheral edge of the substrate, the composition for forming a wafer-edge-protection film is coated also on an edge surface on a rear surface side of the peripheral edge of the substrate; and in the step (ii), the wafer-edge-protection film is formed also on the edge surface on the rear surface side of the substrate.
[8]: The wafer-edge-protection film forming method of [6] or [7], wherein the coating in the step (i) is performed using a spin coating method, so that the wafer-edge-protection film is not formed on areas other than the peripheral edge of the substrate.
[9]: The wafer-edge-protection film forming method of any one of [6] to [8], wherein, in the step (ii), the coating film is cured by heat treatment at a temperature of 100°C or more and 800°C or less for 10 seconds to 7,200 seconds.
[10]: A patterning process in which a wafer-edge-protection film is formed on a peripheral edge of a substrate to be processed on which a patterned film is formed and a pattern is formed on the substrate to be processed, comprising the steps of:
   (I-1) applying the composition for forming a wafer-edge-protection film of any one of [1] to [5] onto a peripheral edge of a substrate to be processed on which a patterned film is formed to obtain a coating film;
   (I-2) curing the coating film by a heat treatment or optical irradiation to form the wafer-edge-protection film on the peripheral edge of the substrate;
   (I-3) forming a pattern on the substrate to be processed by dry etching while using the patterned film as a mask; and
   (I-4) removing the wafer-edge-protection film.
[11]: A patterning process in which a wafer-edge-protection film is formed on a peripheral edge of a substrate to be processed and a pattern is formed on the substrate to be processed, comprising the steps of:
   (II-1) applying the composition for forming a wafer-edge-protection film of any one of [1] to [5] onto a peripheral edge of a substrate to be processed to obtain a coating film;
   (II-2) curing the coating film by heat treatment or optical irradiation to form a wafer-edge-protection film on the peripheral edge of the substrate to be processed;
   (II-3) forming a resist upper layer film pattern on the substrate to be processed, and forming a pattern on the substrate to be processed by dry etching while using the resist upper layer film pattern as a mask; and
   (II-4) removing the wafer-edge-protection film.
[12]: The patterning process of [10], wherein in the step (I-1), in addition to an edge surface on a front surface side of the peripheral edge of the substrate, the composition for forming a wafer-edge-protection film is applied also onto an edge surface on a rear surface side of the peripheral edge of the substrate; and
   in the step (I-2), the wafer-edge-protection film is formed also on the edge surface on the rear surface side of the substrate.
[13]: The patterning process according to [11], wherein
   in the step (II-1), in addition to an edge surface of the peripheral edge on the front surface side of the substrate, the composition for forming a wafer-edge-protection film is applied also onto an edge surface of the peripheral edge on the rear surface side of the substrate; and
   in the step (II-2), the wafer-edge-protection film is formed also on an edge surface on the rear surface side of the substrate.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a wafer-edge-protection film for forming a wafer-edge-protection film on a peripheral edge of a substrate, comprising:
a polymer (A) represented by the following general formula (1); and
a solvent, 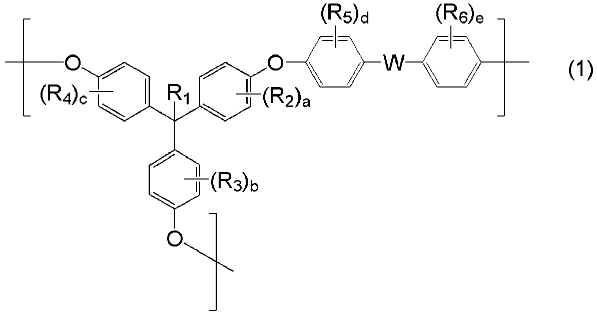
wherein "W" represents -SO₂-, -C(=O) -, or -O-; R₁, R₂, R₃, R₄, and R₅ each independently represent a halogen atom, a monovalent organic group having 1 to 3 carbon atoms, or a hydroxy group; and "a", "b", "c", "d", and "e" each independently represent an integer of 0 to 4.

2. The composition for forming a wafer-edge-protection film according to claim 1, wherein the polymer (A) has a weight-average molecular weight of 1,000 to 30,000.

3. The composition for forming a wafer-edge-protection film according to claim 1 or 2, wherein the polymer (A) is contained in 10 mass% or more.

4. The composition for forming a wafer-edge-protection film according to any one of claims 1 to 3, further comprising one or more kinds of:
a crosslinking agent;
a surfactant;
an acid generator; and
a plasticizer.

5. The composition for forming a wafer-edge-protection film according to any one of claims 1 to 4, wherein the solvent is a mixture of a high-boiling-point solvent having a boiling point of 180°C or more and a low-boiling-point solvent having a boiling point of less than 180°C.

6. A wafer-edge-protection film forming method for forming a wafer-edge-protection film on a peripheral edge of a substrate, comprising the steps of:
(i) coating a peripheral edge of the substrate with the composition for forming a wafer-edge-protection film according to any one of claims 1 to 5 to obtain a coating film; and
(ii) curing the coating film by heat or optical irradiation to form the wafer-edge-protection film on the peripheral edge of the substrate.

7. The wafer-edge-protection film forming method according to claim 6, wherein
in the step (i), in addition to an edge surface on a front surface side of the peripheral edge of the substrate, the composition for forming a wafer-edge-protection film is coated also on an edge surface on a rear surface side of the peripheral edge of the substrate; and
in the step (ii), the wafer-edge-protection film is formed also on the edge surface on the rear surface side of the substrate.

8. The wafer-edge-protection film forming method according to claim 6 or 7, wherein the coating in the step (i) is performed using a spin coating method, so that the wafer-edge-protection film is not formed on areas other than the peripheral edge of the substrate.

9. The wafer-edge-protection film forming method according to any one of claims 6 to 8, wherein, in the step (ii), the coating film is cured by heat treatment at a temperature of 100°C or more and 800°C or less for 10 seconds to 7,200 seconds.

10. A patterning process in which a wafer-edge-protection film is formed on a peripheral edge of a substrate to be processed on which a patterned film is formed and a pattern is formed on the substrate to be processed, comprising the steps of:
(I-1) applying the composition for forming a wafer-edge-protection film according to any one of claims 1 to 5 onto a peripheral edge of a substrate to be processed on which a patterned film is formed to obtain a coating film;
(I-2) curing the coating film by a heat treatment or optical irradiation to form the wafer-edge-protection film on the peripheral edge of the substrate;
(I-3) forming a pattern on the substrate to be processed by dry etching while using the patterned film as a mask; and
(I-4) removing the wafer-edge-protection film, or a patterning process in which a wafer-edge-protection film is formed on a peripheral edge of a substrate to be processed and a pattern is formed on the substrate to be processed, comprising the steps of:
(II-1) applying the composition for forming a wafer-edge-protection film according to any one of claims 1 to 5 onto a peripheral edge of a substrate to be processed to obtain a coating film;
(II-2) curing the coating film by heat treatment or optical irradiation to form a wafer-edge-protection film on the peripheral edge of the substrate to be processed;
(II-3) forming a resist upper layer film pattern on the substrate to be processed, and forming a pattern on the substrate to be processed by dry etching while using the resist upper layer film pattern as a mask; and
(II-4) removing the wafer-edge-protection film.

11. The patterning process according to claim 10, wherein
in the step (I-1), in addition to an edge surface on a front surface side of the peripheral edge of the substrate, the composition for forming a wafer-edge-protection film is applied also onto an edge surface on a rear surface side of the peripheral edge of the substrate; and
in the step (I-2), the wafer-edge-protection film is formed also on the edge surface on the rear surface side of the substrate.

12. The patterning process according to claim 10, wherein
in the step (II-1), in addition to an edge surface of the peripheral edge on the front surface side of the substrate, the composition for forming a wafer-edge-protection film is applied also onto an edge surface of the peripheral edge on a rear surface side of the substrate; and
in the step (II-2), the wafer-edge-protection film is formed also on an edge surface on the rear surface side of the substrate.
